# EUROPEAN PATENT APPLICATION

(11) **EP 4 783 799 A1**
(43) Date of publication of application: **29.07.2026**
(21) Application number: 26151130.7
(22) Date of filing: 09.01.2026
(51) Int. Cl.: H10K 59/122, H10K 59/123, H10K 59/80

(54) **DISPLAY DEVICE HAVING DISPLAY AREA TRENCH, ELECTRONIC DEVICE INCLUDING THE SAME AND METHOD FOR PROVIDING THE SAME**

(30) Priority: 17.01.2025 KR 20250007385
(71) Applicant: Samsung Display Co., Ltd., Yongin-si, Gyeonggi-do 17113 (KR)
(72) Inventor: YANG, Hee Jun, Yongin-si (KR); KIM, A Rong, Yongin-si (KR); KIM, Jae Ik, Yongin-si (KR); MOON, Young Min, Yongin-si (KR); LEE, Sa Min, Yongin-si (KR)
(74) Representative: Marks & Clerk LLP

(57) **Abstract**

A display area (DDA) of a display device (10) includes insulating layers (ILD1, ILD2, ILD3) of a transistor layer (TFL) on a substrate (SUB), and a display element layer (EML) electrically connected to the transistor layer (TFL). The display element layer (EML) includes a bank (BN) in which a bank opening (OP2) in a non-emission area (NLA) and an anode contact hole (ACTH) in the emission area (EA) are defined, the bank (BN) having an overhang structure at the bank opening (OP2) and a side surface which defines the anode contact hole (ACTH), an element insulating layer (PDL) in the anode contact hole (ACTH) and covering the side surface of the bank (BN), a light emitting element (EL) on the element insulating layer (PDL), and a trench (T) which is in the non-emission area (NLA) and adjacent to the light emitting element (EL). The trench (T) penetrates through the bank (BN) of the display element layer (EML) and the insulating layers (ILD1-ILD3) of the transistor layer (TFL) to expose the substrate (SUB) to the trench (T).

## Description

### BACKGROUND

### 1. Field

The present disclosure relates to a display device, an electronic device using the same, and a method for fabricating (or providing) the same.

### 2. Description of the Related Art

As the information society develops, the demand for display devices for displaying images has increased and diversified. For example, display devices have been applied to various electronic devices such as smartphones, digital cameras, laptop computers, navigation devices, and smart televisions. The display devices may be flat panel display devices such as liquid crystal display devices, field emission display devices, or organic light emitting display devices. Among such flat panel display devices, a light emitting display device may display an image without a backlight unit providing light to a display panel since each of the pixels of the display panel includes light emitting elements which may emit light by themselves.

### SUMMARY

Aspects of the present disclosure provide a display device capable of providing a high-resolution image, an electronic device using the same, and a method for fabricating (or providing) the same.

Aspects of the present disclosure also provide a display device physically robust against bending stress applied by bending and a form change repeatedly applied, an electronic device using the same, and a method for fabricating the same.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

In an embodiment of the disclosure, a display device includes an emission area and a non-emission area, a transistor layer located on a substrate and including a plurality of insulating layers, a bank structure located on the transistor layer, and having an overhang structure, an anode contact hole penetrating through the bank structure, a first element insulating layer overlapping the anode contact hole and covering a side surface of the bank structure, a first light emitting element located on the first element insulating layer, and a second light emitting element spaced apart from the first light emitting element with a trench portion disposed between the first light emitting element and the second light emitting element, where the trench portion defines a non-emission opening by penetrating through the bank structure and the plurality of insulating layers of the transistor layer, and the substrate is exposed in a portion overlapping the non-emission opening.

In an embodiment, the bank structure may include a first bank layer, a second bank layer located on the first bank layer, and a third bank layer having a tip protruding more than a side surface of the second bank layer toward the non-emission area, and the first bank layer, the second bank layer, and the third bank layer surround the anode contact hole.

In an embodiment, the trench portion may penetrate through the first bank layer.

In an embodiment, in a plan view, the first bank layer may surround the non-emission opening, and in a plan view, the first bank layer having a mesh shape.

In an embodiment, the first light emitting element may overlap a first emission area, the second light emitting element overlaps a second emission area, in a plan view, the third bank layer surrounding the first emission area and the third bank layer surrounding the second emission area are spaced apart from each other, and in a plan view, the third bank layer surrounding the first emission area and the third bank layer surrounding the second emission area are connected to each other by the first bank layer.

In an embodiment, the display device may further include a second element insulating layer located on the first element insulating layer and defining an emission opening, where the first light emitting element includes a first light emitting layer located on an anode electrode and entirely covering the second element insulating layer, a cathode electrode located on the first light emitting layer and in contact with the tip of the third bank layer, and an auxiliary electrode located on the cathode electrode and in contact with the side surface of the second bank layer.

In an embodiment, the second light emitting element may include a second light emitting layer spaced apart from the first light emitting layer with the trench portion disposed between the first light emitting layer and the second light emitting layer, a cathode electrode located on the second light emitting layer, and an auxiliary electrode located on the cathode electrode, and the cathode electrode and the auxiliary electrode included in the first light emitting element are spaced apart from the cathode electrode and the auxiliary electrode included in the second light emitting element with the trench portion disposed between the cathode electrode and the auxiliary electrode included in the first light emitting element and the cathode electrode and the auxiliary electrode included in the second light emitting element.

In an embodiment, the display device may further include an anode planarization layer located between the anode electrode and the first element insulating layer, where the anode planarization layer fills the anode contact hole, and the anode planarization layer overlapping the first light emitting element and the anode planarization layer overlapping the second light emitting element are spaced apart from each other with the trench portion disposed between the anode planarization layer overlapping the first light emitting element and the anode planarization layer overlapping the second light emitting element.

In an embodiment, the display device may further include a first element inorganic layer located on the first light emitting element, and a second element inorganic layer located on the second light emitting element, where the first element inorganic layer and the second element inorganic layer are spaced apart from each other with the trench portion disposed between the first element inorganic layer and the second element inorganic layer, and the first element inorganic layer and the second element inorganic layer do not overlap the non-emission opening.

In an embodiment, the display device may further include an organic encapsulation layer located on the first element inorganic layer and the second element inorganic layer, where in the portion overlapping the non-emission opening, the organic encapsulation layer fills the trench portion, and in the portion overlapping the non-emission opening, the organic encapsulation layer is in contact with the substrate.

In an embodiment, side surfaces of the plurality of insulating layers facing the trench portion and a side surface of the first bank layer facing the trench portion may be entirely covered by the organic encapsulation layer.

In an embodiment, the substrate may include polyimide.

In an embodiment of the disclosure, a method for fabricating a display device includes: forming anode contact holes penetrating through a bank structure on a substrate and forming a first element insulating layer and an anode electrode; forming a second element insulating layer defining emission openings and forming tips of the bank structure; forming first to third light emitting elements and first to third element inorganic layers; and forming trench portions by an etching process and forming an organic encapsulation layer on the first to third element inorganic layers.

In an embodiment, in the forming of the trench portions by the etching process and the forming of the organic encapsulation layer on the first to third element inorganic layers, the trench portions do not overlap the first to third light emitting elements and the first to third element inorganic layers, and the etching process is performed up to a portion where the substrate may be exposed.

In an embodiment, in the forming of the trench portions by the etching process and the forming of the organic encapsulation layer on the first to third element inorganic layers, the organic encapsulation layer is in contact with the substrate, and the organic encapsulation layer may completely fill the trench portions.

In an embodiment of the disclosure, an electronic device includes at least one display device including a substrate including an emission area and a non-emission area, and at least one of a display module, a processor, a memory, and a power module connected to the at least one display device, where the at least one display device includes a transistor layer located on the substrate and including a plurality of insulating layers, a bank structure located on the transistor layer, and having an overhang structure, an anode contact hole penetrating through the bank structure, a first element insulating layer overlapping the anode contact hole and covering a side surface of the bank structure, a first light emitting element located on the first element insulating layer, and second light emitting element spaced apart from the first light emitting element with a trench portion disposed between the first light emitting element and the second light emitting element, the trench portion defines a non-emission opening by penetrating through the bank structure and the plurality of insulating layers of the transistor layer, and the substrate is exposed in a portion overlapping the non-emission opening.

At least some of the above and other features of the invention are set out in the claims.

Detailed contents of other embodiments are described in a detailed description and are illustrated in the drawings.

With a display device, an electronic device using the same, and a method for fabricating the same according to embodiments, a display device capable of providing a high-resolution image and physically robust against bending stress caused by repeated application of bending and a form change, an electronic device using the same, and a method for fabricating the same may be provided.

The effects of the present disclosure are not limited to the aforementioned effects, and various other effects are included in the present specification.

### BRIEF DESCRIPTION OF THE DRAWINGS

The above and other aspects and features of the present disclosure will become more apparent by describing in detail embodiments thereof with reference to the attached drawings, in which:
FIGS. 1 and 2 are perspective views illustrating an unfolded form and a folded form of a display device according to an embodiment;
FIG. 3 is a cross-sectional view taken along line A-A' of FIG. 1;
FIG. 4 is a cross-sectional view taken along line B-B' of FIG. 2;
FIGS. 5 and 6 are perspective views illustrating an unfolded form and a folded form of a display device according to an embodiment;
FIGS. 7 and 8 are perspective views illustrating an unfolded form and a folded form of a display device according to an embodiment;
FIG. 9 is a perspective view illustrating a display panel of FIG. 3;
FIG. 10 is a cross-sectional view illustrating the display panel of FIG. 9;
FIG. 11 is a plan view illustrating a display layer in FIG. 10;
FIG. 12 is a plan view illustrating an arrangement of a plurality of pixels in FIG. 11;
FIG. 13 is a cross-sectional view of an example of a display layer taken along line A1-A1' of FIG. 12;
FIG. 14 is an enlarged cross-sectional view of a display element layer overlapping a first emission area in FIG. 13;
FIG. 15 is an enlarged cross-sectional view of area 'A' in FIG. 14;
FIG. 16 is a cross-sectional view of an example of the display layer taken along line A3-A3' of FIG. 12;
FIGS. 17 and 18 are enlarged cross-sectional views of area 'N' in FIG. 16;
FIG. 19 is a plan view illustrating an arrangement of a plurality of pixels disposed in a display area of FIG. 11 in an embodiment;
FIG. 20 is a cross-sectional view of an example of a display layer taken along line C1-C1' of FIG. 19;
FIG. 21 is a cross-sectional view of an example of a display layer taken along line C3-C3' of FIG. 19;
FIG. 22 is a cross-sectional view of an example of a display layer taken along line C5-C5' of FIG. 19;
FIG. 23 is a flowchart illustrating a method for fabricating (or providing) the display layer of FIG. 16;
FIGS. 24 and 25 are cross-sectional views for describing S100 of FIG. 23;
FIGS. 26 to 28 are cross-sectional views for describing S200 of FIG. 23;
FIGS. 29 and 30 are cross-sectional views for describing S300 of FIG. 23;
FIGS. 31 to 33 are cross-sectional views for describing S400 of FIG. 23;
FIG. 34 is a block diagram of an electronic device according to an embodiment; and
FIG. 35 depicts schematic views of electronic devices according to various embodiments.

### DETAILED DESCRIPTION

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being related to another element such as being "on" another element or layer, the element or layer can be directly on another element or layer or intervening elements or layers. In contrast, when an element or layer is referred to as being related to another element such as being "directly on" another element or layer, no intervening element or layer is present therebetween.

Like reference numerals refer to like elements throughout the specification. Shapes, sizes, ratios, angles, numbers, etc. disclosed in the drawings for describing embodiments are merely an example, and the present disclosure is not limited to the illustrated details. Within the Figures and the text of the disclosure, a reference number indicating a singular form of an element may also be used to reference a plurality of the element.

It will be understood that, although the terms first, second, third, etc., may be used herein to describe various elements, these elements should not be limited by these terms. These terms are only used to distinguish one element from another element. Thus, a first element discussed below could be termed a second element without departing from the teachings of the present disclosure.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, embodiments will be described with reference to the accompanying drawings.

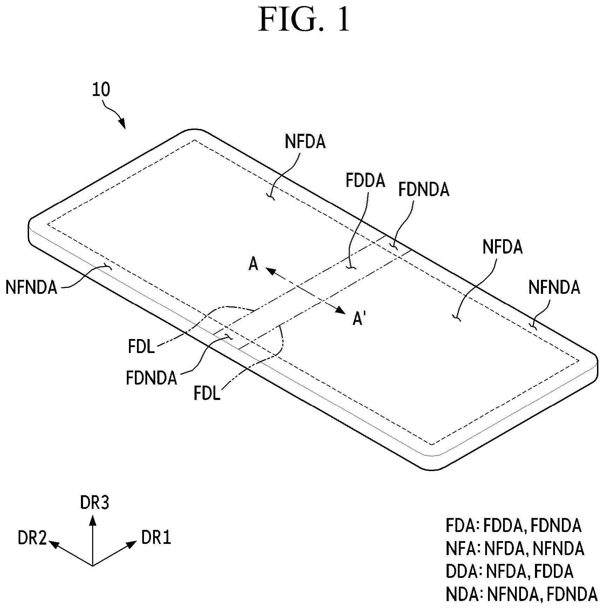

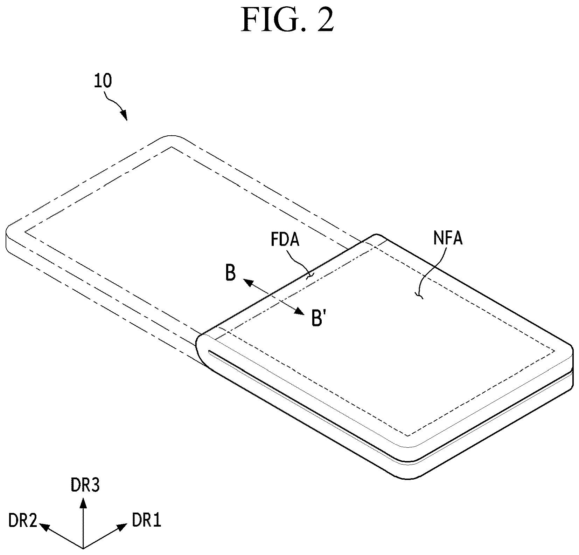

FIGS. 1 and 2 are perspective views illustrating an unfolded form and a folded form of a display device 10 according to an embodiment.

Referring to FIG. 1, a display device 10 according to an embodiment may be applied to portable electronic devices such as mobile phones, smartphones, tablet personal computers (PCs), mobile communication terminals, electronic notebooks, electronic books, portable multimedia players (PMPs), navigation devices, and ultra mobile PCs (UMPCs). As an example, the display device 10 may be applied as a display unit of televisions, laptop computers, monitors, billboards, or the Internet of Things (IOTs). As another example, the display device 10 may be applied to wearable devices such as smart watches, watch phones, glasses-type displays, and head mounted displays (HMDs).

Examples of the display device 10 may include an inorganic light emitting diode display device, an organic light emitting display device, a quantum dot light emitting display device, a plasma display device, a field emission display device, and the like. Hereinafter, a case where the display device 10 is an organic light emitting diode display device will be described by way of example, but the present disclosure is not limited thereto, and the same technical idea may be applied to other display devices if applicable.

The display device 10 may have a planar shape such as a rectangular shape with a great length (e.g., a major dimension) in a second direction DR2, a rectangular shape with a great length in a first direction DR1, a square shape, a rectangular shape with rounded corners (vertices), other polygonal shapes, or a circular shape. The display device 10 may include a display area DDA similar to an overall planar shape of the display device 10. The display device 10 according to an embodiment illustrated in FIG. 1 has a rectangular shape with a great length in the second direction DR2.

One surface of the display device 10 disposed in or parallel to a plane formed by the first direction DR1 and the second direction DR2 crossing each other, may be a display surface of the display device 10 from which light is emitted to provide an image. In addition, a third direction DR3 may be a thickness direction of the display device 10. The third direction DR3 may cross the plane defined by the first direction DR1 and the second direction DR2 crossing each other, such as a normal direction or orthogonal direction. A thickness of the display device 10 and various layers thereof may be defined along the thickness direction,

According to an embodiment, the display device 10 may be a foldable-type display device or a stretchable-type display device. The display device 10 may include a non-folding area provided in plural including a plurality of non-folding areas NFA maintaining a planar form thereof even during bending or stretching and at least one of a folding area FDA disposed between the plurality of non-folding areas NFA. The display device 10 may be changed in bending form (e.g., bent or unbent) and in planar form (e.g., stretched in a planar direction, at the folding area FDA.

As illustrated in FIGS. 1 and 2, the display device 10 according to an embodiment may include two non-folding areas NFA facing each other in the second direction DR2 and one folding area FDA disposed between the two non-folding areas NFA. Two folding lines FDL, which are boundaries between the two non-folding areas NFA and one folding area FDA, may extend in the first direction DR1. An axis about which the display panel 100 is folded, bent, etc. may be extend parallel to a boundary line among the boundary lines, without being limited thereto.

As illustrated in FIG. 1, in the display device 10 of the unfolded form, at least one folding area FDA may have a planar form in which it is completely unfolded flatly in coordinates of the first direction DR1 and the second direction DR2, that is, along a DR1-DR2 plane.

As illustrated in FIG. 2, in the display device 10 of the folded form, at least one folding area FDA may have a bending form in which it is folded or bent. As used herein, a folded form, a bending form, etc. may be a term used to describe a state or a shape of the device.

In an embodiment, the display device 10 may be changed into a folded form of in-folding (e.g., in-folded) in which display surfaces of the plurality of non-folding areas NFA face each other and are hidden from the outside (e.g., the outside of the display device 10 which is in-folded) by bending of the folding area FDA of the bending form.

Alternatively, in an embodiment, the display device 10 may be changed into a folded form of out-folding (e.g., out-folded) in which display surfaces of the plurality of non-folding areas NFA face in directions away from each other and are exposed to the outside while overlapping each other by bending of the folding area FDA of the bending form.

In an embodiment, the folding area FDA included in the display device 10 may have a form in which it is stretched in the first direction DR1 or the second direction DR2. That is, the display device 10 may be planarly deformed in one or more directions along a plane, such as the DR1-DR2 plane.

The display surface of the display device 10 may include a display area DDA from which light for displaying an image is emitted and a non-display area NDA which is disposed adjacent to the display area DDA and from which light is not emitted. In an embodiment, the non-display area NDA may be extended around the display area DDA, such as to surround the display area DDA in a plan view (e.g., along the third direction DR3).

The display area DDA may include a plurality of non-folding display areas NFDA overlapping the plurality of non-folding areas NFA and at least one folding display area FDDA overlapping at least one folding area FDA.

The non-display area NDA may include a plurality of non-folding non-display areas NFNDA overlapping the plurality of non-folding areas NFA and at least one folding non-display area FDNDA overlapping at least one folding area FDA. In other words, a total planar area of each of the plurality of non-folding areas NFA may include a non-folding display area NFDA and a non-folding non-display area NFNDA. In addition, a total planar area of at least one folding area FDA may include a folding display area FDDA and a folding non-display area FDNDA.

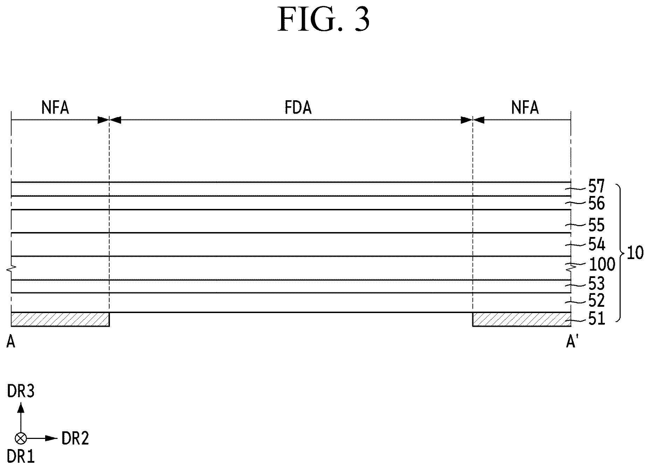

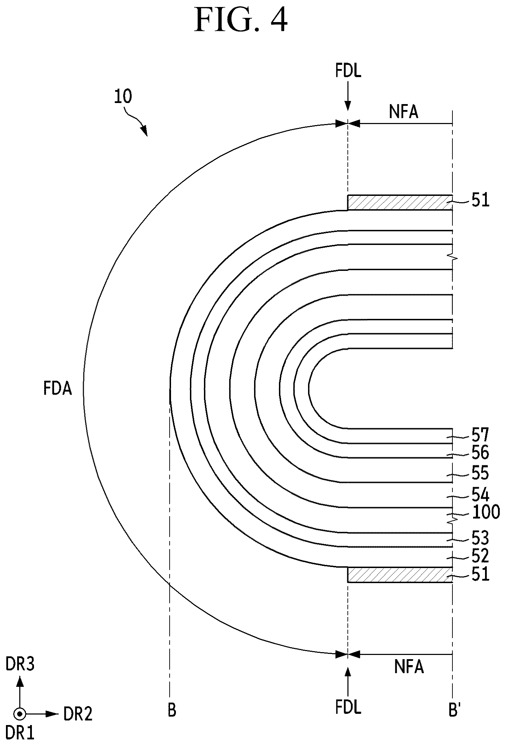

FIG. 3 is a cross-sectional view taken along line A-A' of FIG. 1, and FIG. 4 is a cross-sectional view taken along line B-B' of FIG. 2.

Referring to FIGS. 3 and 4, the display device 10 according to an embodiment may include a display panel 100 emitting light for displaying an image, a polymer film layer 53 disposed beneath a rear surface of the display panel 100 opposite to a display surface of the display panel 100, a cushion layer 52 disposed beneath the polymer film layer 53, a heat dissipation member 51 disposed beneath the cushion layer 52 and overlapping the plurality of non-folding areas NFA, an anti-reflection member 54 disposed on the display surface of the display panel 100, an impact absorption layer 55 disposed on the anti-reflection member 54, a cover window 56 disposed on the impact absorption layer 55, and a window protection layer 57 disposed on the cover window 56.

The anti-reflection member 54 is used to reduce external light reflection, and may include a polarizing film.

The impact absorption layer 55 is used to cushion external impact transferred from the cover window 56 to the display panel 100, and may include a transparent soft material or a transparent elastic material.

The cover window 56 is used to protect the display surface of the display panel 100 so that the display surface of the display panel 100 is not directly exposed to physical impact, and may include a transparent rigid material. As an example, the cover window 56 may include glass or plastic.

The window protection layer 57 is used to prevent scattering of the cover window 56, absorb impact, prevent a scratch, prevent a fingerprint, and prevent glare, and may include a transparent polymer film.

The polymer film layer 53 is used to protect the rear surface of the display panel 100 from electrical impact, and may include an insulating (e.g., electrically insulating) material. As an example, the polymer film layer 53 may include polyimide (PI), polyethylene terephthalate (PET), polycarbonate (PC), polyethylene (PE), polypropylene (PP), polysulfone (PSF), polymethyl methacrylate (PMMA), triacetyl cellulose (TAC), a cycloolefin polymer (COP), or the like. The polymer film layer 53 may further include a light absorption layer including a black pigment or a black dye so that light is not emitted to the rear surface of the display panel 100.

The cushion layer 52 is used to protect the rear surface of the display panel 100 from physical impact, and may include a cushioning material. As an example, the cushion layer 52 may include polyurethane or the like.

The heat dissipation member 51 is used to dissipate heat generated by the display panel 100, and may include a metal material having relatively high thermal conductivity. As an example, the heat dissipation member 51 may include a metal material such as copper or silver or include graphite or a carbon nanotube.

The heat dissipation member 51 includes a metal material having relatively low ductility, and accordingly, may not be disposed in at least one folding area FDA.

As illustrated in FIG. 4, the display device 10 may have a folded form of in-folding. In the display device 10 changed into the folded form of the in-folding, the plurality of non-folding areas NFA may overlap each other along a thickness direction of the display device 10 which is folded, and the heat dissipation member 51 may be exposed to the outside while display surfaces of the plurality of non-folding areas NFA face each other and are hidden from the outside. In addition to the above-described embodiment, the display device 10 may include folding areas FDA and non-folding areas NFA having various forms.

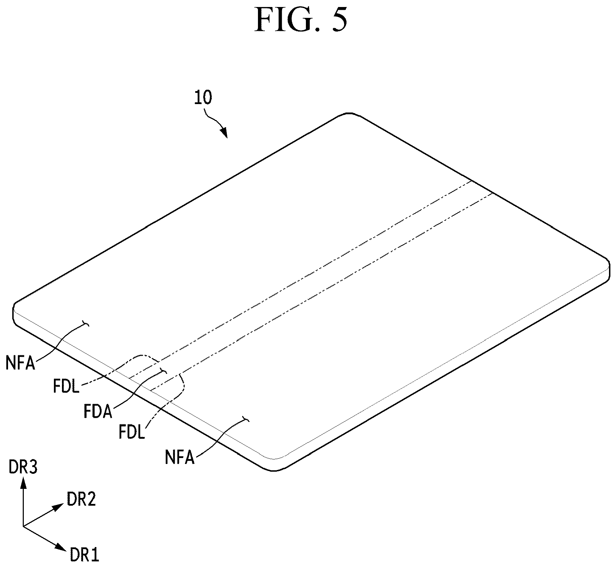

FIGS. 5 to 8 are perspective views illustrating an unfolded form and a folded form of a display device 10 according to an embodiment.

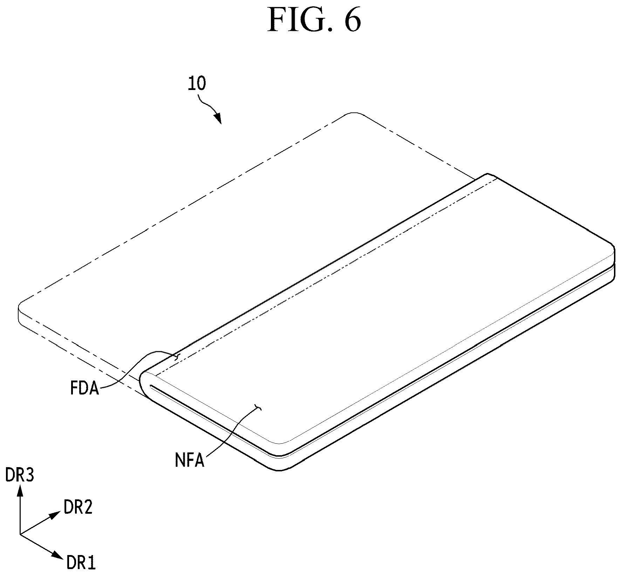

Referring to FIGS. 5 and 6, a display device 10 may include two non-folding areas NFA arranged in the first direction DR1, and one folding area FDA disposed between the two non-folding areas NFA. Two folding lines FDL, which are boundaries between the two non-folding areas NFA and one folding area FDA, may extend in the second direction DR2. An overlapping description is omitted.

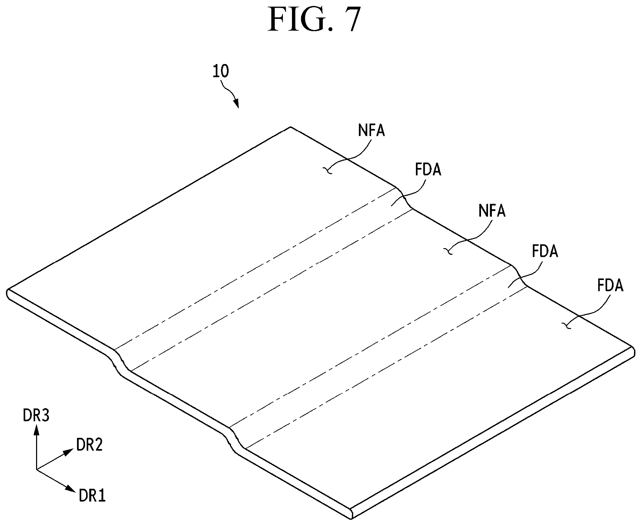

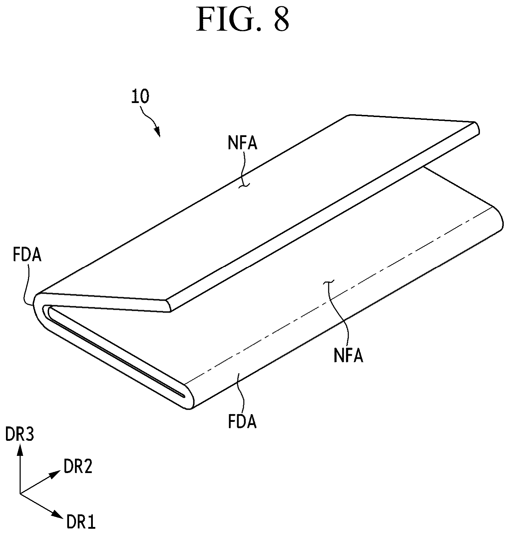

Referring to FIGS. 7 and 8, a display device 10 may include three non-folding areas NFA arranged in the first direction DR1, and two folding areas FDA disposed between the three non-folding areas NFA. In the display device 10, a form of one of the two folding areas FDA may be changed in an in-folding manner, and a form of the other of the two folding areas FDA may be changed in an out-folding manner. Accordingly, the display device 10 may be folded as illustrated in FIG. 8.

As described above, in an embodiment, the folding area FDA included in the display device 10 illustrated in FIGS. 5 to 8 may have a form in which it is stretched in a planar direction, such as along the first direction DR1 or the second direction DR2 in a DR1-DR2 plane.

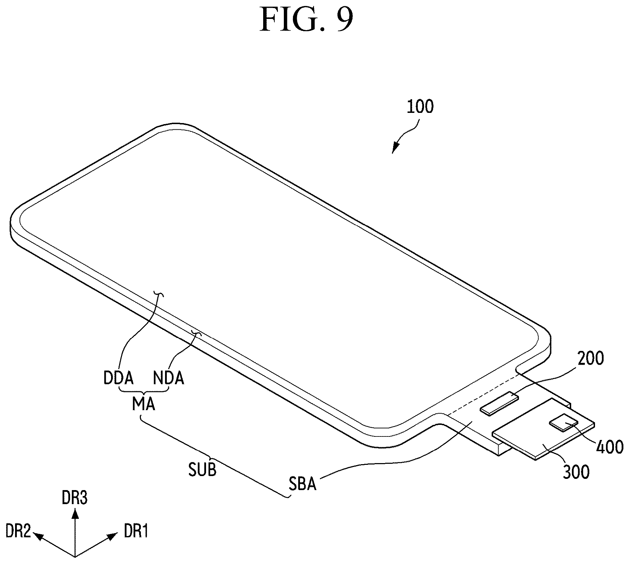

FIG. 9 is a perspective view illustrating a display panel 100 of FIG. 3.

Referring to FIG. 9, the display panel 100 may have a planar shape similar to a rectangular shape in a plan view. For example, the display panel 100 may have a shape similar to a rectangular shape, in the plan view, having short sides in the first direction DR1 and long sides in the second direction DR2. A corner where the short side in the first direction DR1 and the long side in the second direction DR2 meet may be rounded with a selected curvature or right-angled. A shape of the display panel 100 in the plan view is not limited to the rectangular shape, and may be a planar shape similar to other polygonal shapes, a circular shape, or an elliptical shape.

The display panel 100 may include a substrate SUB, a display driver 200, a circuit board 300, and a touch driver 400.

The substrate SUB may include a main area MA and a sub-area SBA. The main area MA may include a display area DDA including pixels displaying an image and a non-display area NDA which is adjacent to, such as located around, the display area DDA. Images may not be displayed in the sub-area SBA, without being limited thereto.

The display area DDA may emit light from a plurality of emission areas or a plurality of openings to be described later. For example, the substrate SUB may include pixel circuits including switching elements, an element insulating layer defining the emission areas or the openings, and self-light emitting elements. For example, the self-light emitting element may include at least one of an organic light emitting diode (LED) including an organic light emitting layer, a quantum dot LED including a quantum dot light emitting layer, an inorganic LED including an inorganic semiconductor, and a micro LED, but is not limited thereto. It has been illustrated in the drawings that the self-light emitting element is an organic light emitting diode.

The non-display area NDA may be an area outside the display area DDA. The non-display area NDA may be defined as an edge area of the main area MA of the substrate SUB.

The sub-area SBA may be an area extending from one side of the main area MA. The sub-area SBA may include a flexible material which may be bent, folded, and rolled. For example, when the sub-area SBA is bent, the sub-area SBA may overlap the main area MA in the thickness direction (e.g., the third direction DR3). The sub-area SBA may include the display driver 200 and pad portions (not shown) at which the display panel 100 is connected (physically and/or electrically) to the circuit board 300. In an embodiment, the sub-area SBA may be omitted, and the display driver 200 and the pad portions may be located in the non-display area NDA.

The display driver 200 may output signals and voltages for driving elements on the substrate SUB. The display driver 200 may be formed (or provided) as an integrated circuit (IC) and mounted on the substrate SUB in a chip on glass (COG) manner, a chip on plastic (COP) manner, or an ultrasonic bonding manner. As an example, the display driver 200 may be located in the sub-area SBA, and may overlap the main area MA in the thickness direction by bending of the sub-area SBA. As an example, the display driver 200 may be mounted on the circuit board 300.

The circuit board 300 may be attached onto the pad portions of the substrate SUB using an anisotropic conductive film (ACF). The circuit board 300 may be a flexible printed circuit board, a printed circuit board, or a flexible film such as a chip on film.

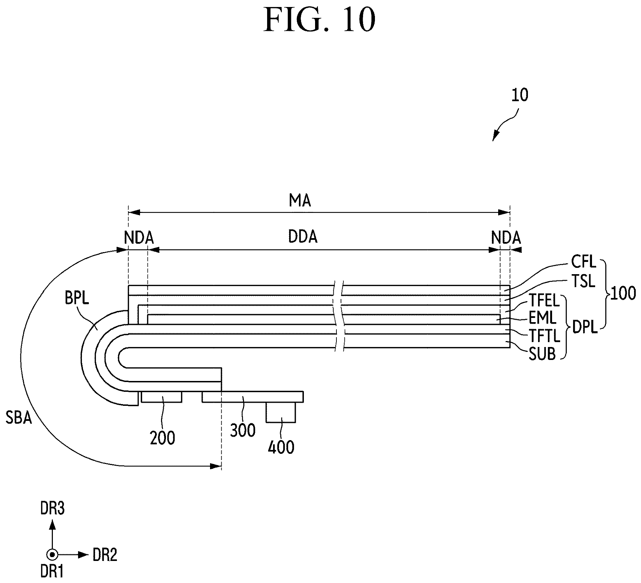

The touch driver 400 may be mounted on the circuit board 300. The touch driver 400 may be connected to a touch sensor layer TSL (see FIG. 10) for sensing and driving a touch.

FIG. 10 is a cross-sectional view illustrating the display panel 100 of FIG. 9 which is bent at the sub-area SBA.

Referring to FIG. 10, in cross section, the display panel 100 included in the display device 10 may include a display layer DPL, a touch sensor layer TSL, and a color filter layer CFL. The display layer DPL may include a substrate SUB, a transistor layer TFTL, a display element layer EML, and a thin film encapsulation layer TFEL.

The substrate SUB may be a base substrate or a base member. The substrate SUB may be a flexible substrate which may be bent, folded, rolled, and stretched.

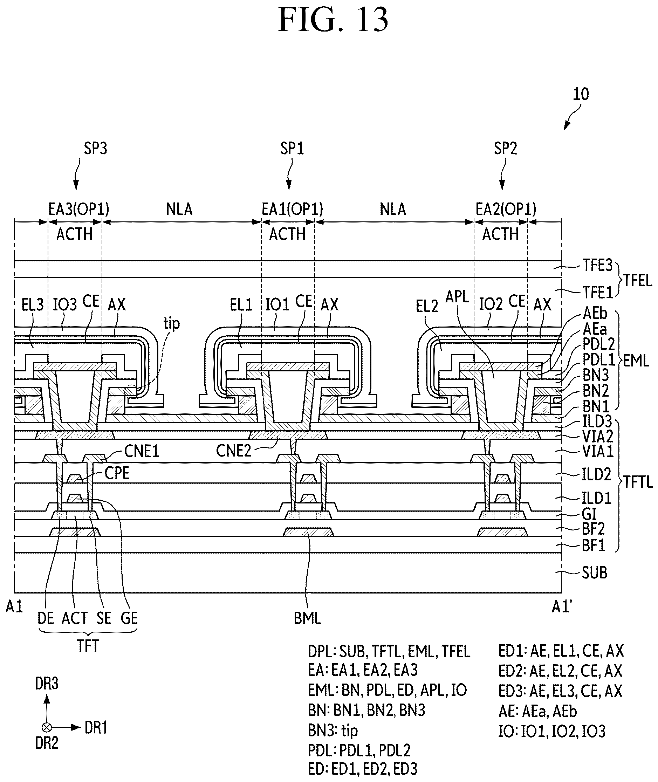

The transistor layer TFTL as a circuit layer may be located on the substrate SUB. The transistor layer TFTL may be located in a portion overlapping the display area DDA, the non-display area NDA, and the sub-area SBA. The transistor layer TFTL may include a plurality of transistors TFT (see FIG. 13).

The display element layer EML may be located on the transistor layer TFTL. The display element layer EML may be located in a portion overlapping the display area DDA. The display element layer EML may include at least one of an organic light emitting diode (LED) including an organic light emitting layer, a quantum dot LED including a quantum dot light emitting layer, an inorganic LED including an inorganic semiconductor, and a micro LED, but is not limited thereto.

The thin film encapsulation layer TFEL as an encapsulation layer may be located on the display element layer EML. The thin film encapsulation layer TFEL may be located in a portion overlapping the display area DDA and the non-display area NDA. The thin film encapsulation layer TFEL may cover an upper surface and side surfaces of the display element layer EML, and may protect the display element layer EML from external oxygen and moisture. The thin film encapsulation layer TFEL may include at least one inorganic film and at least one organic film for encapsulating the display element layer EML. The thin film encapsulation layer TFEL may be omitted according to embodiments.

The touch sensor layer TSL as a sensing layer may be located on the thin film encapsulation layer TFEL. The touch sensor layer TSL may be located in the portion overlapping the display area DDA and the non-display area NDA. The touch sensor layer TSL may sense an external input such as a user's touch in a mutual capacitance manner or a self-capacitance manner. The touch sensor layer TSL may be omitted according to embodiments.

The color filter layer CFL as a light control layer may be located on the touch sensor layer TSL. The color filter layer CFL may be located in the portion overlapping the display area DDA and the non-display area NDA. The color filter layer CFL may absorb some of light introduced from the outside of the display device 10 to reduce reflected light by external light. Accordingly, the color filter layer CFL may prevent distortion of emitted or displayed colors due to external light reflection.

Since the color filter layer CFL is directly disposed on the touch sensor layer TSL, the display device 10 may not require a separate substrate for the color filter layer CFL. Accordingly, a total thickness of the display device 10 may be relatively small. The color filter layer CFL may also be omitted according to embodiments.

As illustrated in FIG. 10, a portion of the display panel 100 may be bendable such as to be bent. When a portion of the display panel 100 is bent, the display driver 200, the circuit board 300, and the touch driver 400 may overlap the main area MA in the third direction DR3.

In addition, when a portion of the display panel 100 is bent, a bending protection layer BPL may protect an underlying structure overlapping the sub-area SBA from bending stress. The display panel 100 which is unbent may include the bending protection layer BPL coplanar with layers like the display element layer EML, etc.

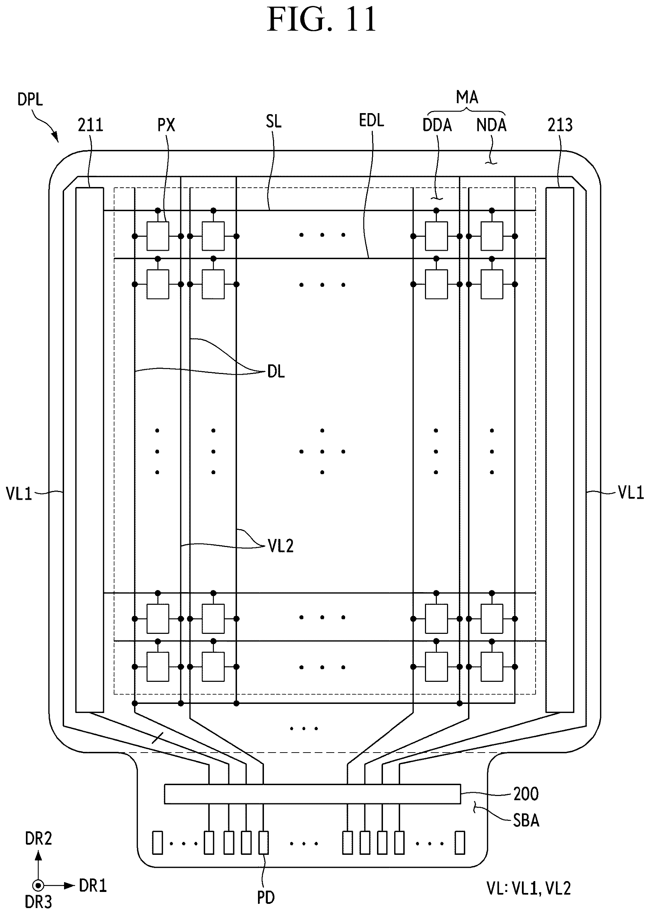

FIG. 11 is a plan view illustrating a display layer DPL in FIG. 10.

Referring to FIG. 11, the display layer DPL may include a pixel PX provided in plural including a plurality of pixels PX located in a portion overlapping the display area DDA, and a plurality of power lines VL, a scan line SL provided in plural including a plurality of scan lines SL, an emission control line EDL provided in plural including a plurality of emission control lines EDL, and a data line DL provided in plural including a plurality of data lines DL which are variously connected to the plurality of pixels PX.

The plurality of scan lines SL may extend in the first direction DR1, and may be spaced apart from each other in the second direction DR2 crossing the first direction DR1. The scan lines SL may be arranged along the second direction DR2. The scan lines SL may sequentially supply scan signals to the plurality of pixels PX.

The emission control lines EDL may extend in the first direction DR1, and may be spaced apart from each other in the second direction DR2. The emission control lines EDL may be arranged along the second direction DR2. The emission control lines EDL may sequentially supply emission signals to the plurality of pixels PX.

The data lines DL may extend in the second direction DR2, and may be spaced apart from each other in the first direction DR1. The data lines DL may be arranged along the first direction DR1. The data lines DL may supply data voltages to the plurality of pixels PX. The data voltage may determine luminance of each of the plurality of pixels PX.

The power line VL may include a main power line VL1 and a sub-power line which is provided in plural including sub-power lines VL2. At least one of a first source voltage (high potential voltage) or a second source voltage (low potential voltage) may be transferred to the sub-power supply lines VL2 through the main power supply line VL1 overlapping the non-display area NDA. Hereinafter, the main power supply line VL1 and the sub-power supply line VL2 may be collectively referred to as the power line VL.

The non-display area NDA may surround the display area DDA in the plan view. The non-display area NDA may include a scan driver 211 and an emission control driver 213.

The scan driver 211 may be disposed outside one side of the display area DDA or on one side of the non-display area NDA. The scan driver 211 may include a plurality of driving transistors generating gate signals based on a gate control signal.

The emission control driver 213 may be disposed outside the other side of the display area DDA or on the other side of the non-display area NDA which is opposite to the one side. The emission control driver 213 may include a plurality of emission control transistors generating emission signals based on an emission control signal.

The display layer DPL included in an embodiment may include the display driver 200 and a pad electrode PD a plurality of pad electrodes PD in a pad portion overlapping the sub-area SBA. The plurality of pad electrodes PD may be spaced apart from each other in the first direction DR1, and the respective pad electrodes PD may be connected to respective different lines (e.g., signal lines, power lines, etc.) described above.

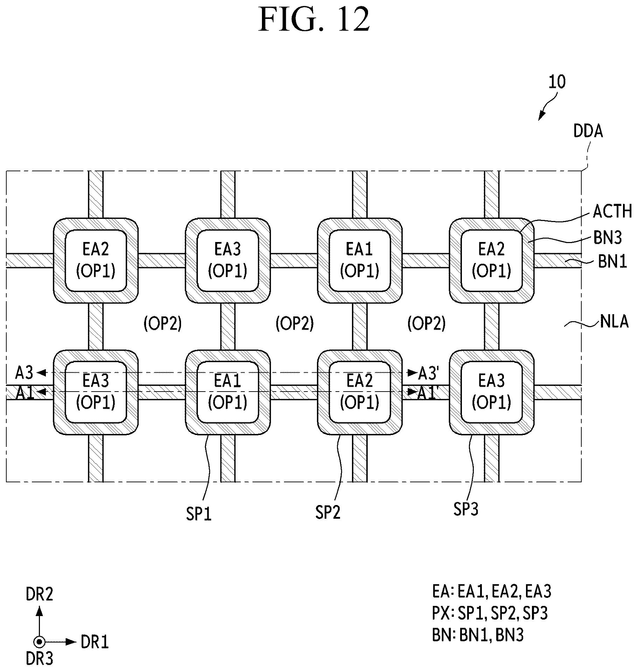

FIG. 12 is a plan view illustrating an arrangement of a plurality of pixels PX in FIG. 11. The display area DDA illustrated in FIG. 12 may overlap the folding area FDA and/or the non-folding area NFA illustrated in FIGS. 1 to 8. As an example, when the display area DDA illustrated in FIG. 12 overlaps the folding area FDA, the display device 10 according to an embodiment may have a structure easy for a foldable type. In addition, when the display area DDA illustrated in FIG. 12 is formed simultaneously in the folding area FDA and the non-folding area NFA, the display device 10 according to an embodiment may have a structure easy for a stretchable type.

Referring to FIG. 12, the pixel PX according to an embodiment may include a first sub-pixel SP1, a second sub-pixel SP2, and a third sub-pixel SP3 located in a portion overlapping the display area DDA. The first sub-pixel SP1, the second sub-pixel SP2, and the third sub-pixel SP3 may be spaced apart from each other.

The pixel PX may include an emission area EA. The emission area EA may be a portion from which light is emitted. As an example, the first sub-pixel SP1 may include a first emission area EA1, the second sub-pixel SP2 may include a second emission area EA2, and the third sub-pixel SP3 may include a third emission area EA3.

In an embodiment, the first emission area EA1, the second emission area EA2, and the third emission area EA3 may emit light of different colors. As an example, the first emission area EA1 may emit red light, the second emission area EA2 may emit green light, and the third emission area EA3 may emit blue light. However, the present disclosure is not limited thereto, and according to embodiments, the first emission area EA1, the second emission area EA2, and the third emission area EA3 may also emit light of the same color.

In an embodiment, the emission area EA may be defined by an emission opening OP1 defined in a layer. The emission opening OP1 may be defined by an element insulating layer PDL (see FIG. 13) to be described later. Detailed contents will be described later.

In the plan view, an anode contact hole ACTH may be located in a portion overlapping the emission area EA. In other words, in the plan view, the anode contact hole ACTH may be located in a portion overlapping the emission opening OP1.

The display device 10 according to an embodiment may include a non-emission area NLA in the portion overlapping the display area DDA. The non-emission area NLA may surround the first emission area EA1, the second emission area EA2, and the third emission area EA3, and may prevent color mixing of light emitted from the first emission area EA1, the second emission area EA2, and the third emission area EA3.

In the plan view, a bank structure BN as a bank layer may be located in a portion overlapping the non-emission area NLA. The bank structure BN may surround the emission opening OP1 or the anode contact hole ACTH.

Specifically, in the plan view, a third bank layer BN3 as a third thickness portion included in the bank structure BN may be formed in the form of one conductive pattern surrounding the emission opening OP1, the emission area EA, or the anode contact hole ACTH. Accordingly, the third bank layer BN3 surrounding the first emission area EA1, the third bank layer BN3 surrounding the second emission area EA2, and the third bank layer BN3 surrounding the third emission area EA3 may be spaced apart from each other.

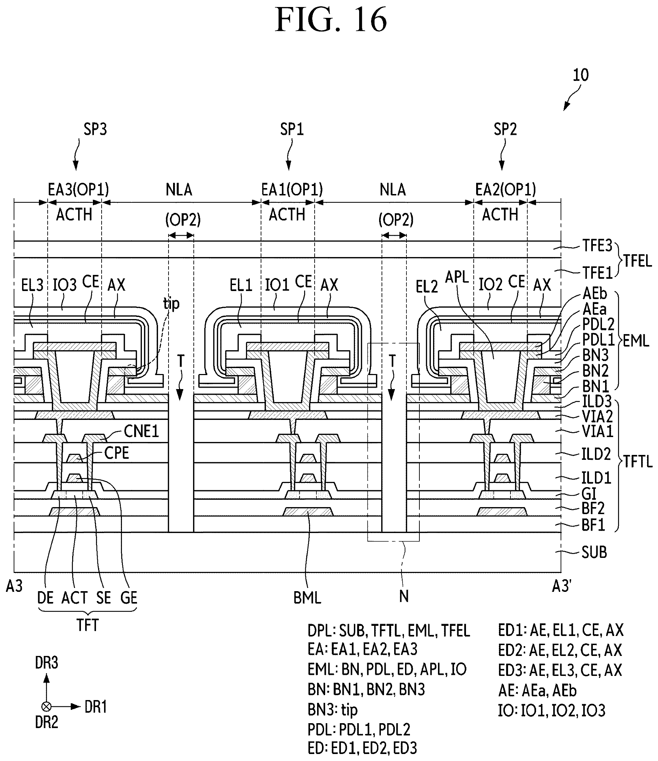

In the plan view, non-emission openings OP2 may be located in the portion overlapping the non-emission area NLA. The non-emission opening OP2 may be defined by a trench portion T (see FIG. 16) to be described later. Detailed contents will be described later.

In the plan view, a first bank layer BN1 as a first thickness portion may be located in the portion overlapping the non-emission area NLA. In the plan view, the first bank layer BN1 may surround the non-emission opening OP2. In other words, in the plan view, the first bank layer BN1 may be formed as one conductive pattern connected while exposing the non-emission opening OP2, and may have a mesh shape.

In an embodiment, the bank structure BN may have a mesh shape defined by solid portions spaced apart from each other with spaces or openings therebetween. The second bank layer BN2 and the third bank layer BN3 corresponding to the emission areas EA may form an enclosed shape in the plan view, to surround the emission openings OP1. These enclosed shapes (BN2 together with BN3) may be connected to each other by the first bank layer BN1. The extended portions of the first bank layer BN1 may surround the non-emission openings OP2. Referring to FIG. 12, for example, the extended portions of the first bank layer BN1 together with the enclosed shapes of the bank structure BN may form an overall mesh shape of the bank structure BN.

In an embodiment, the first bank layer BN1 may serve as an electrical bridge. Specifically, the third bank layer BN3 surrounding the first emission area EA1, the third bank layer BN3 surrounding the second emission area EA2, and the third bank layer BN3 surrounding the third emission area EA3 may be electrically connected to each other by the first bank layer BN1. A detailed description will be provided later.

For convenience of explanation, it has been illustrated in FIG. 12 that the first bank layer BN1 has a linear shape, but the present disclosure is not limited thereto. In the plan view, the first bank layer BN1 may also have a shape such as a zigzag shape and a wave shape.

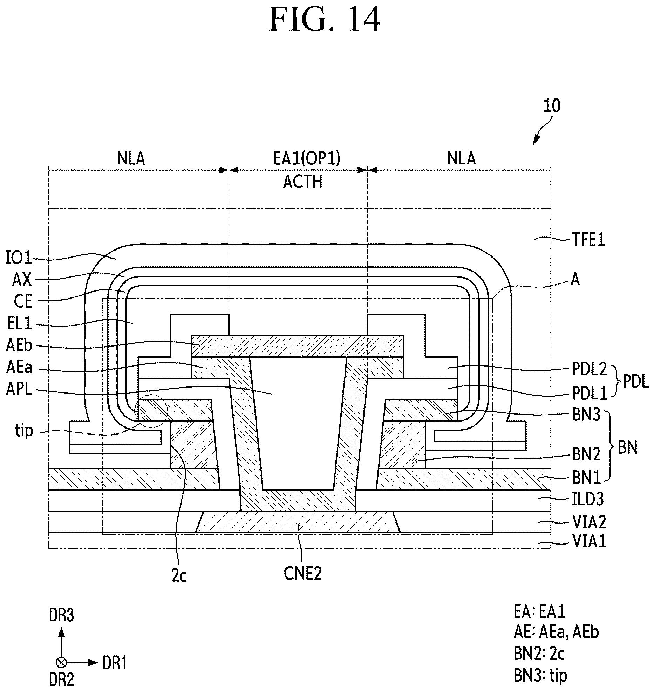

FIG. 13 is a cross-sectional view of an example of a display layer DPL taken along line A1-A1' of FIG. 12, and FIG. 14 is an enlarged cross-sectional view of a display element layer EML overlapping a first emission area EA1 in FIG. 13. A cross-sectional structure of the first sub-pixel SP1, the second sub-pixel SP2, and the third sub-pixel SP3 overlapping the emission openings OP1 in the portion overlapping the display area DDA of the display device 10 has been illustrated in FIG. 13.

Referring to FIGS. 13 and 14 in addition to FIGS. 1 to 12, in an embodiment, the substrate SUB may include a polymer resin such as polyimide (PI). Accordingly, the substrate SUB may be flexible so as to be able to be bent, folded, or rolled.

The transistor layer TFTL may be located on the substrate SUB. The transistor layer TFTL may include a first buffer layer BF1, bottom metal layers BML, a second buffer layer BF2, transistors TFT, a gate insulating layer GI, a first insulating layer ILD1, capacitor electrodes CPE, a second insulating layer ILD2, first connection electrodes CNE1, a first via layer VIA1, second connection electrodes CNE2, a second via layer VIA2, and a third insulating layer ILD3.

The first buffer layer BF1 may be located on the substrate SUB. The first buffer layer BF1 may include an inorganic film capable of preventing permeation of air or moisture. For example, the first buffer layer BF1 may include a plurality of inorganic films which are alternately stacked.

The bottom metal layers BML may be located on the first buffer layer BF1. The bottom metal layer BML may include patterns of a conductive metal. As an example, the bottom metal layer BML may be formed as a single layer or multiple layers made of any one of molybdenum (Mo), aluminium (Al), chromium (Cr), gold (Au), titanium (Ti), nickel (Ni), neodymium (Nd), and copper (Cu), or alloys thereof.

In an embodiment, the bottom metal layer BML may be located in a portion overlapping the emission area EA, the emission opening OP1, or the anode contact hole ACTH.

The second buffer layer BF2 may cover the first buffer layer BF1 and the bottom metal layers BML. The second buffer layer BF2 may include an inorganic film capable of preventing permeation of air or moisture. For example, the second buffer layer BF2 may include a plurality of inorganic films which are alternately stacked.

The transistor TFT may be disposed on the second buffer layer BF2, and may constitute a pixel circuit. As an example, the transistor TFT may be a driving transistor or a switching transistor of the pixel circuit.

In an embodiment, the transistor TFT may be located in the portion overlapping the emission area EA, the emission opening OP1, or the anode contact hole ACTH.

The transistor TFT may include an active layer ACT, a source electrode SE, a drain electrode DE, and a gate electrode GE.

The active layer ACT may be located on the second buffer layer BF2. The active layer ACT may overlap the gate electrode GE in the third direction DR3, and may be insulated from the gate electrode GE by the gate insulating layer GI. The source electrode SE and the drain electrode DE may be formed by making portions of the active layer ACT conductors.

The gate insulating layer GI may be located on the active layer ACT. The gate insulating layer GI may cover the active layer ACT and the second buffer layer BF2, and may insulate the active layer ACT and the gate electrode GE from each other. The gate insulating layer GI may include contact holes defined therein through which the first connection electrodes CNE1 penetrate. Such contact holes may penetrate completely through a thickness of the gate insulating layer GI.

The gate electrode GE may be located on the gate insulating layer GI. The gate electrode GE may overlap the active layer ACT with the gate insulating layer GI. The gate insulating layer GI may be disposed between the gate electrode GE and the active layer ACT.

The gate electrode GE may include a conductive metal. As an example, the gate electrode GE may be formed as a single layer or multiple layers made of any one of molybdenum (Mo), aluminium (Al), chromium (Cr), gold (Au), titanium (Ti), nickel (Ni), neodymium (Nd), and copper (Cu), or alloys thereof.

In an embodiment, the gate electrode GE may be located in the portion overlapping the emission area EA, the emission opening OP1, or the anode contact hole ACTH.

The first insulating layer ILD1 may cover the gate electrode GE and the gate insulating layer GI. The first insulating layer ILD1 may include contact holes through which the first connection electrodes CNE1 penetrate. The contact holes of the first insulating layer ILD1 may be connected to the contact holes of the gate insulating layer GI and contact holes of the second insulating layer ILD2, such as to form a single or continuous contact hole.

The capacitor electrodes CPE may be located on the first insulating layer ILD1. The capacitor electrode CPE may overlap the gate electrode GE in the third direction DR3. The capacitor electrode CPE and the gate electrode GE may form capacitance.

In an embodiment, the capacitor electrode CPE may be located in the portion overlapping the emission area EA, the emission opening OP1, or the anode contact hole ACTH.

The second insulating layer ILD2 may cover the capacitor electrodes CPE and the first insulating layer ILD1. The second insulating layer ILD2 may include contact holes through which the first connection electrodes CNE1 penetrate. The contact holes of the second insulating layer ILD2 may be connected to the contact holes of the first insulating layer ILD1 and the contact holes of the gate insulating layer GI.

The first connection electrodes CNE1 may be located on the second insulating layer ILD2. The first connection electrode CNE1 may electrically connect the drain electrode DE of the transistor TFT, and the second connection electrode CNE2 to each other. The first connection electrode CNE1 may be inserted into or extend completely through the contact holes formed in the first insulating layer ILD1, the second insulating layer ILD2, and the gate insulating layer GI to be in contact with the drain electrode DE of the transistor TFT. As being in contact, elements may form an interface therebetween.

In an embodiment, the first connection electrode CNE1 may be located in the portion overlapping the emission area EA, the emission opening OP1, or the anode contact hole ACTH.

The first via layer VIA1 may be located on the first connection electrode CNE1 and the second insulating layer ILD2. The first via layer VIA1 may planarize an underlying structure. The first via layer VIA1 may include contact holes through which the second connection electrodes CNE2 penetrate.

The first via layer VIA1 may include an organic insulating material. As an example, the first via layer VIA1 may include an acrylic resin, polyimide, polyamide, benzocyclobutene, a phenolic resin, and the like.

The second connection electrodes CNE2 may be located on the first via layer VIA1. The second connection electrode CNE2 may be located in the portion overlapping the emission area EA. The second connection electrode CNE2 may be inserted into the contact hole formed in the first via layer VIA1 to be in contact with the first connection electrode CNE1.

In an embodiment, the second connection electrode CNE2 may be located in the portion overlapping the emission area EA, the emission opening OP1, or the anode contact hole ACTH.

The second via layer VIA2 may be located on the first via layer VIA1. The second via layer VIA2 may planarize a step formed by the second connection electrode CNE2.

The second via layer VIA2 may include an organic material. As an example, the second via layer VIA2 may an acrylic resin, a silicone resin, a silicone acrylic resin, an epoxy resin, polyimide, polyamide, benzocyclobutene, a phenolic resin, and the like.

The third insulating layer ILD3 may be located on the second via layer VIA2. The third insulating layer ILD3 may assist in preventing an outgas caused by the organic material of the second via layer VIA2 from permeating into the display element layer EML.

The third insulating layer ILD3 may include an inorganic insulating material. As an example, the third insulating layer ILD3 may include at least one of silicon nitride, silicon oxide, and silicon oxynitride.

The display element layer EML may be disposed on the transistor layer TFTL. The display element layer EML may include a bank structure BN, an element insulating layer PDL, a light emitting element ED, an anode planarization layer APL, and an element inorganic layer IO.

The bank structure BN may be disposed on the third insulating layer ILD3. The bank structure BN may be located in the portion overlapping the emission area EA, the emission opening OP1, or/and the anode contact hole ACTH. In addition, the bank structure BN may be located in the portion overlapping the non-emission area NLA.

The bank structure BN may assist first to third light emitting elements ED1, ED2, and ED3 to be located in portions overlapping the first to third emission areas EA1, EA2, and EA3, respectively, and may assist cathode electrodes CE located in the first to third emission areas EA1, EA2, and EA3 so as to be spaced apart from each other to be electrically connected to each other.

The bank structure BN may include a first bank layer BN1 as a first thickness portion, a second bank layer BN2 as a second thickness portion, and a third bank layer BN3 as a third thickness portion. The first bank layer BN1, the second bank layer BN2, and the third bank layer BN3 may be sequentially stacked in the third direction DR3.

The first bank layer BN1 may be located on the third insulating layer ILD3. The first bank layer BN1 may cover the third insulating layer ILD3 in portions overlapping the emission area EA or the non-emission area NLA.

The first bank layer BN1 may assist in applying a low potential voltage to the cathode electrode CE.

The first bank layer BN1 may include a conductive metal having etching resistance. As an example, the first bank layer BN1 may include titanium (Ti).

The first bank layer BN1 may be penetrated by the anode contact hole ACTH in the portion overlapping the emission area EA. In other words, the first bank layer BN1 may surround the anode contact hole ACTH, and may be formed in the form of one conductive pattern surrounding the anode contact hole ACTH.

The second bank layer BN2 may be located on the first bank layer BN1 so as to be in contact with the first bank layer BN1. The second bank layer BN2 may be penetrated by the anode contact hole ACTH in the portion overlapping the emission area EA. In other words, the second bank layer BN2 may surround the anode contact hole ACTH.

The number of second bank layers BN2 may be plural, and the plurality of second bank layers BN2 may be spaced apart from each other in the first direction DR1. In other words, the plurality of second bank layers BN2 may be located in the portions overlapping the first to third emission areas EA1, EA2, and EA3, respectively, and the respective second bank layers BN2 may be spaced apart from each other in an island shape.

The second bank layer BN2 may assist the first bank layer BN1 and the third bank layer BN3 to be electrically connected to each other. In other words, the second bank layer BN2 may be electrically connected to the first bank layer BN1 and the third bank layer BN3. Accordingly, the second bank layer BN2 located in the portion overlapping the first emission area EA1, the second bank layer BN2 located in the portion overlapping the second emission area EA2, and the second bank layer BN2 located in the portion overlapping the third emission area EA3 may be electrically connected to each other by the first bank layer BN1.

The second bank layer BN2 may include a metal having high electrical conductivity. As an example, the second bank layer BN2 may include aluminium (Al).

The third bank layer BN3 may be located on the second bank layer BN2 so as to be in contact with the second bank layer BN2. The third bank layer BN3 may be penetrated by the anode contact hole ACTH in the portion overlapping the emission area EA. In other words, the third bank layer BN3 may surround the anode contact hole ACTH.

The number of third bank layer BN3 may be plural, and the plurality of third bank layer BN3 may be spaced apart from each other in the first direction DR1. In other words, the plurality of third bank layer BN3 may be located in the portions overlapping the first to third emission areas EA1, EA2, and EA3, respectively, and the respective third bank layer BN3 may be spaced apart from each other in an island shape.

The third bank layer BN3 may include a conductive metal having etching resistance. As an example, the third bank layer BN3 may include titanium (Ti).

In an embodiment, the third bank layer BN3 located in the portion overlapping the first emission area EA1, the third bank layer BN3 located in the portion overlapping the second emission area EA2, and the third bank layer BN3 located in the portion overlapping the third emission area EA3 may be electrically connected to each other through the second bank layer BN2 and the first bank layer BN1. An overlapping description is omitted.

As illustrated in FIG. 14, the second bank layer BN2 may include a first side surface 2c as an outer side surface facing the non-emission area NLA, and the third bank layer BN3 may include a tip tip protruding more than (e.g., further than) the first side surface 2c of the second bank layer BN2 in the first direction DR1. Accordingly, the first side surface 2c of the second bank layer BN2 and the tip tip of the third bank layer BN3 may form an undercut, and the bank structure BN may have an overhang structure.

The display device 10 according to an embodiment may include a first light emitting element ED1, a second light emitting element ED2, and a third light emitting element ED3 spaced apart from each other without a separate fine metal mask in a fabricating process since the bank structure BN includes the tip tip. The fabricating process will be described later.

The element insulating layer PDL may include a first element insulating layer PDL1 and a second element insulating layer PDL2.

The first element insulating layer PDL1 may be located on the third bank layer BN3. The first element insulating layer PDL1 may cover the third bank layer BN3, and may overlap the tip tip of the third bank layer BN3 in the third direction DR3.

The first element insulating layer PDL1 may be penetrated by the anode contact hole ACTH in the portion overlapping the emission area EA. In other words, the first element insulating layer PDL1 may surround the anode contact hole ACTH.

The first element insulating layer PDL1 may allow the bank structure BN and an anode electrode AE to be spaced apart and insulated from each other so that the bank structure BN and the anode electrode AE are not in contact with each other. Accordingly, the first element insulating layer PDL1 may entirely cover a side surface of the bank structure BN facing the anode contact hole ACTH. For this reason, the first element insulating layer PDL1 may solve a short-circuit defect of the display device 10 due to the contact between the anode electrode AE and the bank structure BN.

The first element insulating layer PDL1 may include an inorganic insulating material. As an example, the first element insulating layer PDL1 may include at least one of silicon nitride, silicon oxide, and silicon oxynitride.

The second element insulating layer PDL2 may be located on the first element insulating layer PDL1. The second element insulating layer PDL2 may define the emission opening OP1, and may expose the anode electrode AE in a portion overlapping the emission opening OP1. In other words, the second element insulating layer PDL2 may surround the emission opening OP1, and may cover an edge of the anode electrode AE.

The second element insulating layer PDL2 may include an inorganic insulating material. As an example, the second element insulating layer PDL2 may include at least one of silicon nitride, silicon oxide, and silicon oxynitride.

The light emitting element ED according to an embodiment may be located on the bank structure BN. The light emitting element ED may overlap the bank structure BN and the element insulating layer PDL in the third direction DR3. In addition, the light emitting element ED may overlap the anode contact hole ACTH in the third direction DR3.

The display device 10 according to an embodiment may be applied to a high-resolution electronic device. Accordingly, a plurality of light emitting elements ED included in the display device 10 may be required to be disposed while securing an appropriate spacing distance within a narrow area. Accordingly, the display device 10 according to an embodiment may include the plurality of light emitting elements efficiently disposed within a narrow area by forming the light emitting elements ED to be located on the bank structure BN.

The light emitting element ED may include a first light emitting element ED1 disposed in the first emission area EA1, a second light emitting element ED2 disposed in the second emission area EA2, and a third light emitting element ED3 disposed in the third emission area EA3. The first light emitting element ED1, the second light emitting element ED2, and the third light emitting element ED3 may be spaced apart from each other.

The first light emitting element ED1 may include an anode electrode AE, a first light emitting layer EL1, a cathode electrode CE, and an auxiliary electrode AX, the second light emitting element ED2 may include an anode electrode AE, a second light emitting layer EL2, a cathode electrode CE, and an auxiliary electrode AX, and the third light emitting element ED3 may include an anode electrode AE, a third light emitting layer EL3, a cathode electrode CE, and an auxiliary electrode AX.

The first light emitting element ED1, the second light emitting element ED2, and the third light emitting element ED3 may emit light of different colors. As an example, the first light emitting element ED1 may emit red light, the second light emitting element ED2 may emit green light, and the third light emitting element ED3 may emit blue light. The colors of the light emitted by the first light emitting element ED1, the second light emitting element ED2, and the third light emitting element ED3 may be determined by the first light emitting layer EL1, the second light emitting layer EL2, and the third light emitting layer EL3.

In an embodiment, the anode contact hole ACTH may be located in the portion overlapping the emission area EA. The anode contact hole ACTH may be formed to penetrate through the third insulating layer ILD3, the first bank layer BN1, the second bank layer BN2, and the third bank layer BN3.

In the display device 10 according to an embodiment, an area of the anode contact hole ACTH is not formed in a separate space, and is formed to overlap the emission area EA, and thus, a contact area of the anode electrode AE and the emission area EA may be integrated with each other. Accordingly, in the display device 10 according to an embodiment, a plurality of emission areas EA may be efficiently disposed within a narrow area.

The anode electrode AE may be located on the first element insulating layer PDL1. The anode electrode AE may be located in the portion overlapping the emission area EA, the emission opening OP1, or/and the anode contact hole ACTH.

The anode electrode AE may include a first conductive layer AEa and a second conductive layer AEb. The first conductive layer AEa and the second conductive layer AEb may be sequentially stacked in the third direction DR3.

The first conductive layer AEa may be located on the first element insulating layer PDL1. The first conductive layer AEa may be in contact with and cover the first element insulating layer PDL1, and may extend and be in contact with the circuit layer at the second connection electrode CNE2. In other words, the first conductive layer AEa may entirely cover the first element insulating layer PDL1 and the third insulating layer ILD3 and may extend and be in contact with the second connection electrode CNE2, in the portion overlapping the anode contact hole ACTH. Accordingly, the first conductive layer AEa may be electrically connected to the second connection electrode CNE2.

The bank structure BN includes a bank (solid portion or bank material) in which various openings are defined. A first bank opening may be defined corresponding to the non-emission area NLA. A second bank opening may be defined corresponding to a respective emission area. The anode electrode AE may extend through the bank at the second opening thereof, to contact the underlying circuit layer. Here, a contact area of the anode electrode AE may be a planar area at which the first conductive layer AEa overlaps or physically contacts the second connection electrode CNE2 of the circuit layer.

The first conductive layer AEa may cover the first element insulating layer PDL1, the third insulating layer ILD3, and the second connection electrode CNE2 at a uniform thickness along a profile formed by the first element insulating layer PDL1, the third insulating layer ILD3, and the second connection electrode CNE2. Accordingly, the first conductive layer AEa may include a step which is the same as a shape of an underlying structure. The meaning of the uniform thickness described above may include a process error of 10% or less.

The first conductive layer AEa may include transparent conductive oxide (TCO). As an example, the first conductive layer AEa may include at least one of indium zinc oxide (IZO) and indium tin oxide (ITO).

The second conductive layer AEb may be located on the first conductive layer AEa. The second conductive layer AEb may be in contact with a portion of the first conductive layer AEa. Accordingly, the first conductive layer AEa and the second conductive layer AEb may be electrically connected to each other. The second conductive layers AEb may be exposed in portions overlapping the emission openings OP1, and may be in contact with the first to third light emitting layers EL1, EL2, and EL3 in the portions overlapping the emission openings OP1. An edge of the second conductive layer AEb which does not overlap the emission opening OP1 may be covered by the second element insulating layer PDL2.

The second conductive layer AEb may have a stacked film structure in which a layer made of a material having a high work function, such as indium tin oxide (ITO), indium zinc oxide (IZO), zinc oxide (ZnO), or indium oxide (In₂O₃) and a layer made of a reflective material such as silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), or mixtures thereof are stacked. As an example, the second conductive layer AEb may have a multilayer structure of ITO/Mg, ITO/MgF, ITO/Ag, and ITO/Ag/ITO, but is not limited thereto.

In a fabricating process of the display device 10, the first conductive layer AEa and the second conductive layer AEb may be formed in different processes. Accordingly, a boundary surface (e.g., interface) may be formed on one surface where the first conductive layer AEa and the second conductive layer AEb face each other. In the display device 10 according to an embodiment, it can be seen that the first conductive layer AEa and the second conductive layer AEb are formed in different processes through the boundary surface on one surface where the first conductive layer AEa and the second conductive layer AEb face each other.

The anode planarization layer APL may be located between the first conductive layer AEa and the second conductive layer AEb. The anode planarization layer APL may be in contact with the first conductive layer AEa and the second conductive layer AEb, and may be completely surrounded by the first conductive layer AEa and the second conductive layer AEb in the portion overlapping the anode contact hole ACTH.

The anode planarization layer APL may planarize the step included in the first conductive layer AEa in the portion overlapping the anode contact hole ACTH.

The display device 10 according to an embodiment includes the anode planarization layer APL in the portion overlapping the anode contact hole ACTH, and the step included in the first conductive layer AEa may be planarized. Accordingly, the second conductive layer AEb may have a relatively flat shape, and for this reason, the first to third light emitting layers EL1, EL2, and EL3 may also be formed at a uniform thickness.

The anode planarization layer APL may include an organic material or a conductive metal material.

As an example, when the anode planarization layer APL includes the organic material, the anode planarization layer APL may include an acrylic resin, a silicone resin, a silicone acrylic resin, an epoxy resin, polyimide, polyamide, benzocyclobutene, a phenolic resin, and the like.

As an example, when the anode planarization layer APL includes the conductive metal material, the anode planarization layer APL may include the same material as the first conductive layer AEa of the anode electrode AE. Accordingly, when the anode planarization layer APL includes the conductive metal material, a boundary surface may not be formed between the first conductive layer AEa and the anode planarization layer APL. In other words, when the anode planarization layer APL includes the conductive metal material, the first conductive layer AEa and the anode planarization layer APL may be formed to be viewed as one body. In an embodiment, the anode electrode AE includes a first conductive layer AEa facing a second conductive layer AEb with an anode planarization layer APL therebetween. The anode electrode AE together with the first element insulating layer PDL1 may fill the anode contact hole ACTH of the bank structure BN.

The first to third emitting layers EL1, EL2, and EL3 may be located on the anode electrodes AE. The first to third emitting layers EL1, EL2, and EL3 may be located in the portions overlapping the emission areas EA and the non-emission area NLA. The first to third emitting layers EL1, EL2, and EL3 may overlap the bank structure BN and the element insulating layer PDL in the third direction DR3.

The first to third light emitting layers EL1, EL2, and EL3 may be in contact with the anode electrodes AE in the portions overlapping the emission openings OP1, and may entirely cover the second element insulating layer PDL2 in the portion overlapping the non-emission area NLA.

Each of the first to third light emitting layers EL1, EL2, and EL3 may be an organic light emitting layer made of an organic material. Each of the first to third light emitting layers EL1, EL2, and EL3 may include any material which is generally used.

The first light emitting layer EL1, the second light emitting layer EL2, and the third light emitting layer EL3 may emit light of different colors. As an example, the first light emitting layer EL1 may emit the red light, the second light emitting layer EL2 may emit the green light, and the third light emitting layer EL3 may emit the blue light, but the present disclosure is not limited thereto.

The first light emitting layer EL1 may be located in the portion overlapping the first emission area EA1, the second light emitting layer EL2 may be located in the portion overlapping the second emission area EA2, and the third light emitting layer EL3 may be located in the portion overlapping the third emission area EA3. The first light emitting layer EL1, the second light emitting layer EL2, and the third light emitting layer EL3 may be spaced apart from each other in the portion overlapping the non-emission area NLA.

In the display device 10 according to an embodiment, the third bank layer BN3 includes the tip tip, and accordingly, the first light emitting layer EL1, the second light emitting layer EL2, and the third light emitting layer EL3 spaced apart from each other may be formed without using a separate fine metal mask in the fabricating process of the display device 10. The fabricating process will be described later.

The cathode electrodes CE may be located on the first to third light emitting layers EL1, EL2, and EL3. The cathode electrodes CE may be located in the portions overlapping the emission areas EA and the non-emission area NLA. The cathode electrodes CE may entirely cover the first to third light emitting layers EL1, EL2, and EL3.

The cathode electrode CE may be in contact with the bank structure BN, and for this reason, may be electrically connected to the bank structure BN. Specifically, the cathode electrode CE may be in contact with the tip tip of the third bank layer BN3.

The cathode electrodes CE may transmit the light generated in the first to third light emitting structures EL1, EL2, and EL3 by including a transparent conductive material. As an example, the cathode electrode CE may include a layer made of a material having a small work function, such as Li, Ca, LiF/Ca, LiF/Al, Al, Mg, Ag, Pt, Pd, Ni, Au, Nd, Ir, Cr, BaF, Ba, or compounds or mixtures thereof (e.g., a mixture of Ag and Mg, etc.). The cathode electrode CE may further include a transparent metal oxide layer disposed on the layer made of the material having the small work function.

In an embodiment, the cathode electrode CE located in the portion overlapping the first emission area EA1, the cathode electrode CE located in the portion overlapping the second emission area EA2, and the cathode electrode CE located in the portion overlapping the third emission area EA3 may be spaced apart from each other. The cathode electrodes CE located in the first to third emission areas EA1, EA2, and EA3 so as to be spaced apart from each other may be electrically connected to each other through the bank structure BN.

In the display device 10 according to an embodiment, the third bank layer BN3 includes the tip tip, and accordingly, the cathode electrodes CE located in the first to third emission areas EA1, EA2, and EA3 so as to be spaced apart from each other may be formed without a separate fine metal mask. The fabricating process will be described later.

The auxiliary electrodes AX may be located on the cathode electrodes CE. The auxiliary electrodes AX may be located in the portions overlapping the emission areas EA and the non-emission area NLA. The auxiliary electrodes AX may entirely cover the cathode electrodes CE. The auxiliary electrodes AX may assist the cathode electrodes CE to be electrically connected to each other. In an embodiment, the auxiliary electrodes AX may be considered a thickness portion of the cathode electrodes CE.

The auxiliary electrode AX may include a transparent conductive material (TCO). As an example, the auxiliary electrode AX may include at least one of indium zinc oxide (IZO) and indium tin oxide (ITO).

In an embodiment, the auxiliary electrode AX located in the portion overlapping the first emission area EA1, the auxiliary electrode AX located in the portion overlapping the second emission area EA2, and the auxiliary electrode AX located in the portion overlapping the third emission area EA3 may be spaced apart from each other. The auxiliary electrodes AX located in the first to third emission areas EA1, EA2, and EA3 so as to be spaced apart from each other may be electrically connected to each other through the bank structure BN.

The auxiliary electrode AX may be spaced apart from the first bank layer BN1 in the third direction DR3 in the portion overlapping the non-emission area NLA.

The element inorganic layer IO may be located on the light emitting element ED. The element inorganic layer IO may completely cover the light emitting element ED, and may prevent oxygen or moisture from permeating into the light emitting element ED.

The element inorganic layer IO may include an inorganic insulating material. As an example, the element inorganic layer IO may include any one of silicon nitride, silicon oxide, and silicon oxynitride.

The element inorganic layer IO may include a first element inorganic layer IO1, a second element inorganic layer IO2, and a third element inorganic layer IO3. The first element inorganic layer IO1 may be disposed on the first light emitting element ED1 in the first emission area EA1, the second element inorganic layer IO2 may be disposed on the second light emitting element ED2 in the second emission area EA2, and the third element inorganic layer IO3 may be disposed on the third light emitting element ED3 in the third emission area EA3. The first element inorganic layer IO1, the second element inorganic layer IO2, and the third element inorganic layer IO3 may be spaced apart from each other in the portion overlapping the non-emission area NLA.

It has been illustrated in FIG. 13 that the first element inorganic layer IO1, the second element inorganic layer IO2, and the third element inorganic layer IO3 are formed at a same layer, but in the fabricating process of the display device 10, the first element inorganic layer IO1 may be formed after the first light emitting element ED1 is formed, the second element inorganic layer IO2 may be formed after the second light emitting element ED2 is formed, and the third element inorganic layer IO3 may be formed after the third light emitting element ED3 is formed. The fabricating process will be described later.

As being in or at a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

The thin film encapsulation layer TFEL may be located on the display element layer EML. The thin film encapsulation layer TFEL may include an organic encapsulation layer TFE1 and an inorganic encapsulation layer TFE3.

The organic encapsulation layer TFE1 according to an embodiment may be located on the element inorganic layer IO. As an example, the organic encapsulation layer TFE1 may be in entire contact with and entirely cover the first element inorganic layer IO1, the second element inorganic layer IO2, and the third element inorganic layer IO3.

The organic encapsulation layer TFE1 may planarize a step formed along a profile of an underlying structure. The organic encapsulation layer TFE1 may fill a spaced portion between the auxiliary electrode AX and the first bank layer BN1 in the portion overlapping the non-emission area NLA.

The organic encapsulation layer TFE1 may include a polymer-based material. As an example, the organic encapsulation layer TFE1 may include an acrylic resin, a silicone resin, an epoxy-based resin, a silicone acrylic resin, polyimide, polyethylene, and the like.

The inorganic encapsulation layer TFE3 may be located on the organic encapsulation layer TFE1. The inorganic encapsulation layer TFE3 may protect an underlying structure so that moisture and oxygen do not permeate into the underlying structure. The inorganic encapsulation layer TFE3 may also be omitted according to embodiments.

The inorganic encapsulation layer TFE3 may include an inorganic insulating material. As an example, the inorganic encapsulation layer TFE3 may include any one of silicon nitride, silicon oxide, and silicon oxynitride.

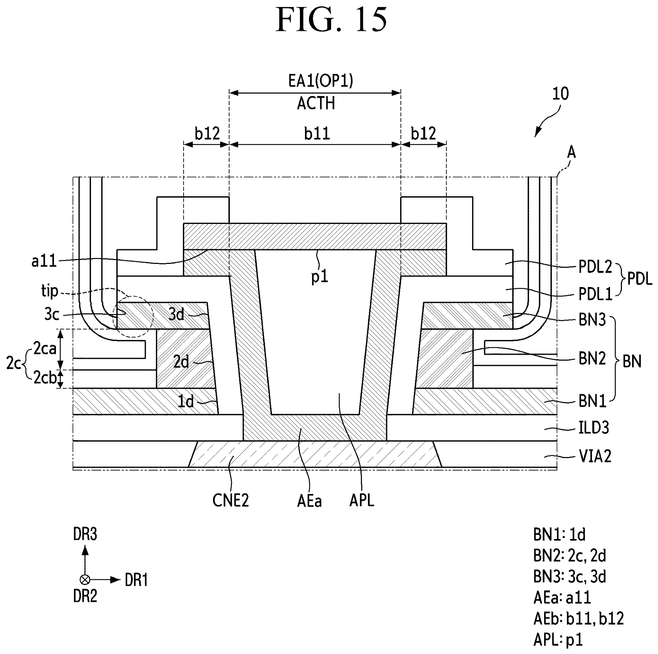

FIG. 15 is an enlarged cross-sectional view of area 'A' in FIG. 14.

Referring to FIG. 15 in addition to FIGS. 1 to 14, the bank structure BN may have an asymmetrical structure in a portion facing the anode contact hole ACTH and a portion opposing the portion facing the anode contact hole ACTH.

As an example, in the portion facing the anode contact hole ACTH, a second side surface 1d of the first bank layer BN1, a second side surface 2d of the second bank layer BN2, and a second side surface 3d of the third bank layer BN3 may be located on the same line. The phrase "located on the same line" described above may have the same meaning as being aligned or extending. In an embodiment, the second side surfaces may be on the same line such as to be coplanar with each other.

The second side surface 1d of the first bank layer BN1, the second side surface 2d of the second bank layer BN2, and the second side surface 3d of the third bank layer BN3 may be provided by the same etching process in the fabricating process of the display device 10, and accordingly, located on the same line.

As an example, in the portion opposing the portion facing the anode contact hole ACTH, a first side surface 3c of the third bank layer BN3 may protrude more than a first side surface 2c of the second bank layer BN2 toward the first direction DR1. That is, the third bank layer BN3 may include the tip tip protruding more than the first side surface 2c of the second bank layer BN2 toward the first direction DR1. An overlapping description is omitted.

In an embodiment, the cathode electrode CE may be located on the first side surface 3c of the third bank layer BN3 so as to be in contact with the first side surface 3c of the third bank layer BN3. In addition, the auxiliary electrode AX may be in contact with the tip tip of the third bank layer BN3, and may extend and be in contact with the second bank layer BN2.

In an embodiment, the first side surface 2c of the second bank layer BN2 may include a first portion 2ca as an upper thickness portion and a second portion 2cb as a lower thickness portion according to thickness portions with which it is in contact. The first portion 2ca may be a portion with which the auxiliary electrode AX is in contact, and the second portion 2cb may be a portion with which the organic encapsulation layer TFE1 is in contact.

In an embodiment, an area where the auxiliary electrode AX is in contact with the bank structure BN may be greater than an area where the cathode electrode CE is in contact with the bank structure BN.

The first element insulating layer PDL1 may be in entire contact with and entirely cover the second side surface 1d of the first bank layer BN1, the second side surface 2d of the second bank layer BN2, and the second side surface 3d of the third bank layer BN3.

The second element insulating layer PDL2 may cover edges of the first conductive layer AEa and the second conductive layer AEb of the anode electrode AE, and may extend and be in contact with the first element insulating layer PDL1.

The second conductive layer AEb of the anode electrode AE may include a first portion b11 and second portions b12 according to portions which it overlaps. The first portion b11 may be a portion in contact with or overlapping the anode planarization layer APL, and the second portions b12 may be portions in contact with or overlapping the first conductive layer AEa. The first portion b11 may be a middle portion of the second conductive layer AEb, and the second portions b12 may be edge portions of the second conductive layer AEb.

In an embodiment, the anode planarization layer APL may include a first surface p1 facing the second conductive layer AEb. In the fabricating process of the display device 10 according to an embodiment, the anode planarization layer APL may be formed by performing a chemical mechanical polishing (CMP) process, and may thus include the first surface p1 of the anode planarization layer APL.

In an embodiment, the first surface p1 of the anode planarization layer APL may extend from a first surface a11 of the first conductive layer AEa in the first direction DR1. The first surface a11 of the first conductive layer AEa may be a surface facing the second conductive layer AEb. The first surfaces may be coplanar with each other.

However, the present disclosure is not limited thereto, and according to embodiments, the first surface p1 of the anode planarization layer APL may have various shapes depending on a process condition.

As an example, the first surface p1 of the anode planarization layer APL may have a convex shape in a direction toward one side of the third direction DR3, that is, in a direction toward the second conductive layer AEb or have a concave shape in a direction toward the other side of the third direction DR3, that is, in a direction toward the second connection electrode CNE2. In other words, the first surface p1 of the anode planarization layer APL may have a cross-sectional shape mechanically or chemically polished by the CMP process.

FIG. 16 is a cross-sectional view of an example of the display layer DPL taken along line A3-A3' of FIG. 12. A cross-sectional structure of the first sub-pixel SP1, the second sub-pixel SP2, and the third sub-pixel SP3 overlapping the emission openings OP1 and the non-emission openings OP2 in the portion overlapping the display area DDA of the display device 10 has been illustrated in FIG. 16.

Referring to FIG. 16 in addition to FIGS. 1 to 15, the display device 10 according to an embodiment may include the non-emission openings OP2 in the portion overlapping the non-emission area NLA. The non-emission openings OP2 may be defined by trench portions T. The trench of the trench portions T may expose the substrate SUB to outside the remaining layers of the transistor layer TFTL and the layers of the display element layer EML.

As described above, the bottom metal layer BML, the transistor TFT, the capacitor electrode CPE, the first connection electrode CNE1, and the second connection electrode CNE2 included in the transistor layer TFTL may be located in the portion overlapping the emission area EA, the emission opening OP1, or the anode contact hole ACTH. In other words, the bottom metal layer BML, the transistor TFT, the capacitor electrode CPE, the first connection electrode CNE1, and the second connection electrode CNE2 included in the transistor layer TFTL may not overlap the non-emission opening OP2.

In addition, the bank structure BN, the element insulating layer PDL, the light emitting element ED, the anode planarization layer APL, and the element inorganic layer IO included in the display element layer EML may be located in the portion overlapping the emission area EA, the emission opening OP1, or the anode contact hole ACTH, and may not overlap the non-emission opening OP2.

Hereinafter, an overlapping description of a structure of the display layer DPL overlapping the emission area EA will be omitted, and a structure of the display layer DPL overlapping the non-emission area NLA will be described.

In an embodiment, the trench portion T as a trench may be formed to penetrate through thickness portions of the transistor layer TFTL. Accordingly, a solid portion of the first buffer layer BF1, the second buffer layer BF2, the gate insulating layer GI, the first insulating layer ILD1, the second insulating layer ILD2, the first via layer VIA1, the second via layer VIA2, and the third insulating layer ILD3 may surround the trench portion T or the non-emission opening OP2. Here, sidewalls or side surfaces of the various layers of the transistor layer TFTL may define the trench within the non-emission area NLA.

In addition, the trench portion T may be formed to penetrate through a thickness portion of the display element layer EML. As an example, the trench portion T may be formed to penetrate through the first bank layer BN1. Accordingly, a solid portion of the first bank layer BN1 may surround the trench portion T in the plan view.

In the fabricating process of the display device 10, the trench portion T may be formed by removing portions (or areas) of the first buffer layer BF1, the second buffer layer BF2, the gate insulating layer GI, the first insulating layer ILD1, the second insulating layer ILD2, the first via layer VIA1, the second connecting electrode CNE2, the second via layer VIA2, the third insulating layer ILD3, and the first bank layer BN1 at once through an etching process. The fabricating process will be described later. Such removal defines sidewalls of the various layers which together define the trench at the trench portions T open in a direction away from the substrate SUB.

The element insulating layer PDL, the light emitting element ED, the anode planarization layer APL, and the element inorganic layer IO included in the display element layer EML may surround the trench portion T or the non-emission opening OP2.

As an example, the element insulating layer PDL located in the portion overlapping the first emission area EA1, the element insulating layer PDL located in the portion overlapping the second emission area EA2, and the element insulating layer PDL located in the portion overlapping the third emission area EA3 may be spaced apart from each other with the trench portion T disposed between such element insulating layers PDL. As being spaced apart, these patterns may be disconnected from each other at the non-emission area NLA (or at the trench or at the non-emission opening OP2.

In addition, the anode planarization layer APL located in the portion overlapping the first emission area EA1, the anode planarization layer APL located in the portion overlapping the second emission area EA2, and the anode planarization layer APL located in the portion overlapping the third emission area EA3 may be spaced apart from each other with the trench portion T disposed between such anode planarization layers APL.

In addition, the first light emitting element ED1, the second light emitting element ED2, and the third light emitting element ED3 may be spaced apart from each other with the trench portion T disposed between the first light emitting element ED1, the second light emitting element ED2, and the third light emitting element ED3, and the first element inorganic layer IO1, the second element inorganic layer IO2, and the third element inorganic layer IO3 may be spaced apart from each other with the trench portion T disposed between the first element inorganic layer IO1, the second element inorganic layer IO2, and the third element inorganic layer IO3.

Furthermore, the bank structure BN located in the portion overlapping the first emission area EA1, the bank structure BN located in the portion overlapping the second emission area EA2, and the bank structure BN located in the portion overlapping the third emission area EA3 may be spaced apart from each other with the trench portion T disposed between such bank structures BN.

As described above, the display device 10 according to an embodiment may have a bending form or a form-changeable structure. This may mean that bending stress due to bending and a form change is repeatedly applied to a portion of the display device 10. As an example, when the bending stress due to the bending and the form change is repeatedly applied to a portion of the display device 10, damage to or breakage of some conductive layers, a plurality of insulating layers, and/or a plurality of via layers included in the display device 10 may occur.

Accordingly, in an embodiment, by forming the bank structure BN, the light emitting element ED, the anode planarization layer APL, the element insulating layer PDL, and the element inorganic layer IO in the portion overlapping the emission area EA to which physical force due to the bending and the form change is not applied and forming the trench portion T in the portion overlapping the non-emission area NLA to which the physical force due to the bending and the form change may be repeatedly applied, it is possible to provide the display device 10 physically robust against the bending stress.

In other words, in the display device 10 according to an embodiment, by forming the trench portion T, it is possible to solve a reliability defect caused by the breakage of or damage to the plurality of insulating layers, the plurality of via layers, and a plurality of conductive layers even though the display device 10 is exposed to the repeated bending stress.

In addition, in the display device 10 according to an embodiment, by forming the first to third light emitting elements ED1, ED2, and ED3 and the first to third element inorganic layers IO1, IO2, and IO3 on the respective bank structures BN overlapping the first to third emission areas EA1, EA2, and EA3, it is possible to solve a reliability defect caused by permeation of external moisture or oxygen even though the display device 10 includes the trench portion T.

In an embodiment, the organic encapsulation layer TFE1 may be located on the substrate SUB so as to be in contact with the substrate SUB in a portion overlapping the non-emission opening OP2. The organic encapsulation layer TFE1 may fill the trench portion T, and may planarize a step formed by the trench portion T.

In an embodiment, a side surface of the first buffer layer BF1, a side surface of the second buffer layer BF2, a side surface of the gate insulating layer GI, a side surface of the first insulating layer ILD1, a side surface of the second insulating layer ILD2, a side surface of the first via layer VIA1, a side surface of the second via layer VIA2, a side surface of the third insulating layer ILD3, and a side surface of the first bank layer BN1 located in a direction toward the trench portion T may be in contact with the organic encapsulation layer TFE1, and may be entirely covered by the organic encapsulation layer TFE1.

In an embodiment, the side surface of the first buffer layer BF1, the side surface of the second buffer layer BF2, the side surface of the gate insulating layer GI, the side surface of the first insulating layer ILD1, the side surface of the second insulating layer ILD2, the side surface of the first via layer VIA1, the side surface of the second via layer VIA2, the side surface of the third insulating layer ILD3, and the side surface of the first bank layer BN1 located in the direction toward the trench portion T (e.g., exposed at the trench) may have various shapes depending on materials included in such layers and a fabricating method performed. A detailed description will be provided later.

In an embodiment, the organic encapsulation layer TFE1 extended in to the gap between the auxiliary electrode AX and the first bank layer BN1 may be located between the auxiliary electrode AX and the first bank layer BN1 in the third direction DR3 to be integral with the organic encapsulation layer TFE1 filling the trench portion T. In other words, steps included in the transistor layer TFTL and the display element layer EML may be planarized by the organic encapsulation layer TFE1. Other overlapping descriptions are omitted. The organic encapsulation layer TFE1 may extend out of the trench to extend along the element inorganic layer IO of the display element layer EML

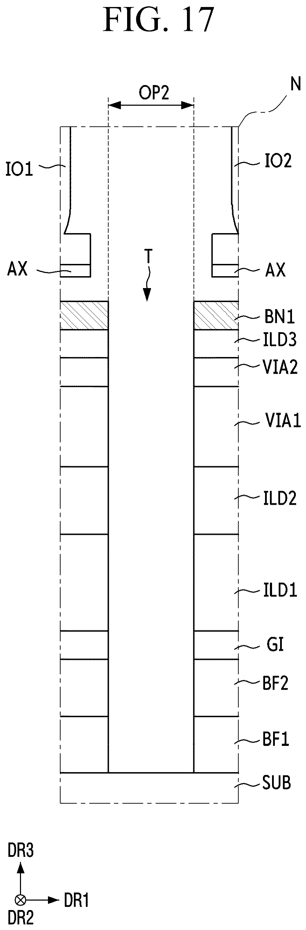

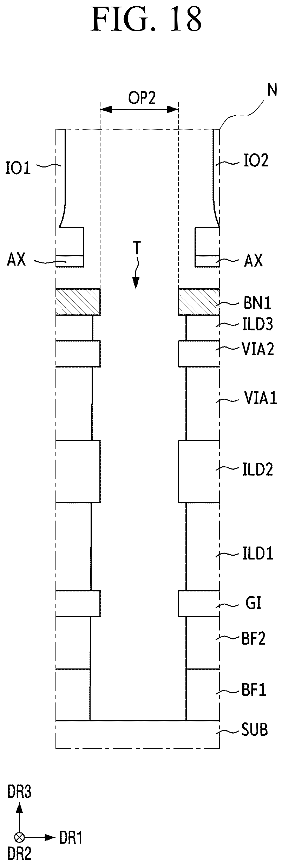

FIGS. 17 and 18 are enlarged cross-sectional views of area 'N' in FIG. 16.

As an example, when the first buffer layer BF1, the second buffer layer BF2, the gate insulating layer GI, the first insulating layer ILD1, the second insulating layer ILD2, and the third insulating layer ILD3 included in the display device 10 include the same inorganic insulating material, the first via layer VIA1 and the second via layer VIA2 included in the display device 10 include the same organic material, and some process conditions (e.g., an etchant and a process time, etc.) of the etching process for forming the trench portion T are adjusted, the side surface of the first buffer layer BF1, the side surface of the second buffer layer BF2, the side surface of the gate insulating layer GI, the side surface of the first insulating layer ILD1, the side surface of the second insulating layer ILD2, the side surface of the first via layer VIA1, the side surface of the second via layer VIA2, the side surface of the third insulating layer ILD3, and the side surface of the first bank layer BN1 located in the direction toward the trench portion T may be located on the same line, as illustrated in FIG. 17. Here, the side surfaces may be coplanar with each other, without being limited thereto.

In other words, in an embodiment, the side surface of the first buffer layer BF1, the side surface of the second buffer layer BF2, the side surface of the gate insulating layer GI, the side surface of the first insulating layer ILD1, the side surface of the second insulating layer ILD2, the side surface of the first via layer VIA1, the side surface of the second via layer VIA2, the side surface of the third insulating layer ILD3, and the side surface of the first bank layer BN1 located in the direction toward the trench portion T may be aligned with each other.

As an example, when the first buffer layer BF1, the second buffer layer BF2, the gate insulating layer GI, the first insulating layer ILD1, the second insulating layer ILD2, and the third insulating layer ILD3 include at least one of the inorganic insulating materials described above and the first via layer VIA1 and the second via layer VIA2 include at least one of the organic materials described above, the side surface of the first buffer layer BF1, the side surface of the second buffer layer BF2, the side surface of the gate insulating layer GI, the side surface of the first insulating layer ILD1, the side surface of the second insulating layer ILD2, the side surface of the first via layer VIA1, the side surface of the second via layer VIA2, the side surface of the third insulating layer ILD3, and the side surface of the first bank layer BN1 located in the direction toward the trench portion T may randomly include shapes protruding in the first direction DR1 and shapes recessed in the first direction DR1, as illustrated in FIG. 18. A shape illustrated in FIG. 18 is only an example, and the side surface of the first buffer layer BF1, the side surface of the second buffer layer BF2, the side surface of the gate insulating layer GI, the side surface of the first insulating layer ILD1, the side surface of the second insulating layer ILD2, the side surface of the first via layer VIA1, the side surface of the second via layer VIA2, the side surface of the third insulating layer ILD3, and the side surface of the first bank layer BN1 located in the direction toward the trench portion T may have various shapes depending on materials included in the respective layers, conditions of processes performed, and the like.

Referring to FIGS. 12, 13, 17 and 18, the trenches may be disconnected from each other in a planar direction along the substrate SUB. The trenches may be separated by stacked structures including layers of the transistor layer TFTL which are on the substrate SUB together with the layers of the display element layer EML. The first bank layer BN1 may protrude from the emission areas EA and into the non-emission area NLA to define an extended portion of the first bank layer BN1 which is between display elements. This extended portion may alternate with trenches, such as along the first direction DR1 and the second direction DR2 as shown in FIG. 12.

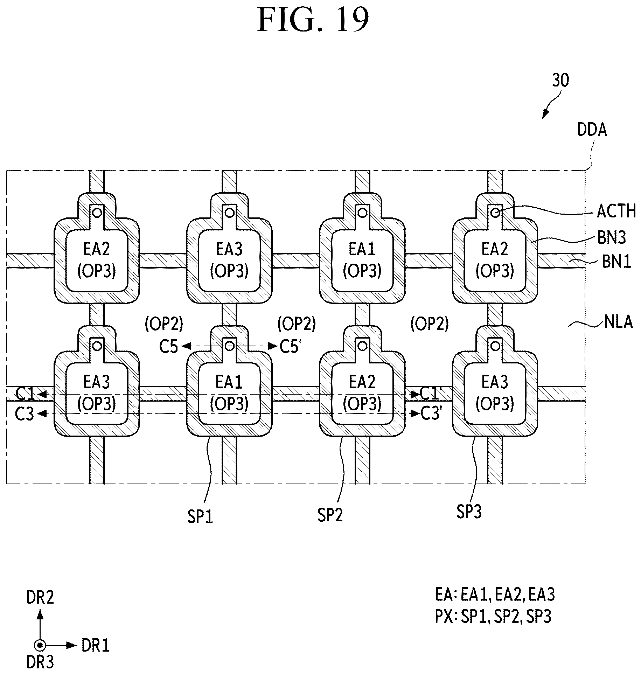

FIG. 19 is a plan view illustrating an arrangement of a plurality of pixels PX disposed in a display area of FIG. 11 in an embodiment.

Referring to FIG. 19 in addition to FIGS. 1 to 18, a pixel PX included in a display device 30 may be different from the pixel PX included in the display device 10 in that it includes an anode contact hole ACTH in a separate area located on one side of an emission area EA. Hereinafter, a common description between the display device 10 and the display device 30 will be omitted, and differences between the display device 10 and the display device 30 will be described later.

The pixel PX included in the display device 30 may include a first sub-pixel SP1, a second sub-pixel SP2, and a third sub-pixel SP3 located in a portion overlapping the display area DDA. The first sub-pixel SP1, the second sub-pixel SP2, and the third sub-pixel SP3 may be spaced apart from each other.

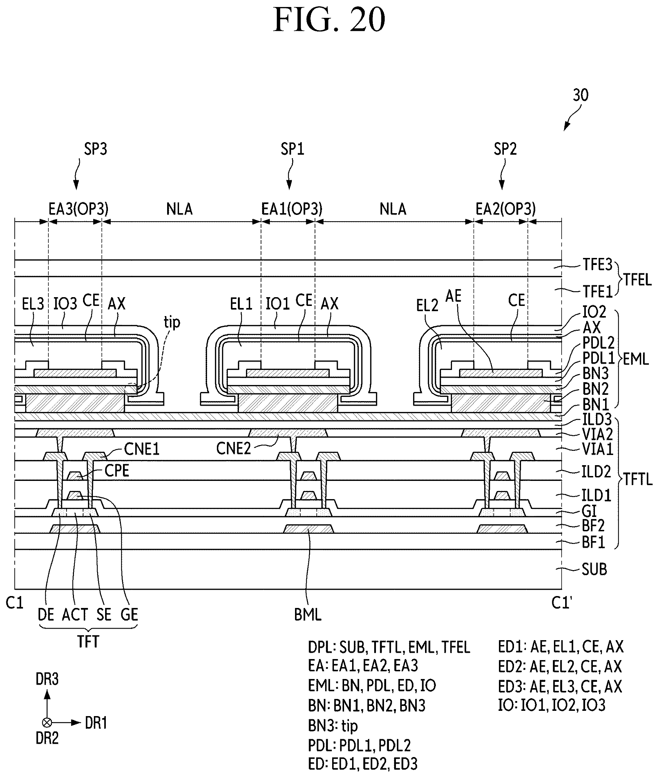

The pixel PX included in the display device 30 may include an emission area EA. The emission area EA may be defined by an emission opening OP3. The emission opening OP3 may be defined by an element insulating layer PDL (see FIG. 20) of the display device 30 to be described later.

The anode contact hole ACTH (or second bank opening) included in the display device 30 may be separately located closer to one side of the emission area EA. It has been illustrated in FIG. 19 that the anode contact hole ACTH is located above the pixel PX in the plan view, but the present disclosure is not limited thereto. A location of the anode contact hole ACTH may be changed according to embodiments.

For convenience of explanation, it has been illustrated in FIG. 19 that a first bank layer BN1 has a linear shape, but the present disclosure is not limited thereto. In a plan view, the first bank layer BN1 may also have a shape such as a zigzag shape and a wave shape. Other overlapping descriptions are omitted.

FIG. 20 is a cross-sectional view of an example of a display layer DPL taken along line C1-C1' of FIG. 19. A cross-sectional structure of the first sub-pixel SP1, the second sub-pixel SP2, and the third sub-pixel SP3 overlapping the emission openings OP3 in the portion overlapping the display area DDA of the display device 30 has been illustrated in FIG. 20.

Referring to FIG. 20 in addition to FIGS. 1 to 19, a display element layer EML included in the display device 30 may have a different structure from the display element layer EML included in the display device 10. Hereinafter, a common structure between a display layer DPL included in the display device 30 and the display layer DPL included in the display device 10 will be omitted, and differences between the display layer DPL included in the display device 30 and the display layer DPL included in the display device 10 will be described later.

The display element layer EML included in the display device 30 may include a bank structure BN, an element insulating layer PDL, a light emitting element ED, and an element inorganic layer IO.

The bank structure BN included in the display device 30 may be disposed on the third insulating layer ILD3 in a portion overlapping the emission area EA. The bank structure BN may be located in a portion overlapping the emission opening OP3, and may be formed without a penetrated portion in the portion overlapping the emission opening OP3, that is, without a second bank opening. The bank structure BN may include a first bank layer BN1, a second bank layer BN2, and a third bank layer BN3.

The third bank layer BN3 included in the display device 30 may have a tip tip protruding more than the second bank layer BN2 toward the non-emission area NLA. In other words, the bank structure BN included in the display device 30 may have an overhang structure.

The element insulating layer PDL included in the display device 30 may include a first element insulating layer PDL1 and a second element insulating layer PDL2 which are sequentially stacked. The first element insulating layer PDL1 and the second element insulating layer PDL2 may be sequentially stacked in the third direction DR3.

The first element insulating layer PDL1 included in the display device 30 may be located on the third bank layer BN3. The first element insulating layer PDL1 may overlap the tip tip of the third bank layer BN3 in the third direction DR3.

The first element insulating layer PDL1 may be located in the portion overlapping the emission opening OP3, and may be formed without a penetrated portion in the portion overlapping the emission opening OP3. In other words, the first element insulating layer PDL1 may entirely cover an upper surface of the third bank layer BN3.

The first element insulating layer PDL1 may insulate the bank structure BN and the anode electrode AE from each other. Accordingly, the first element insulating layer PDL1 may solve a contact defect between the bank structure BN and the anode electrode AE, and may solve a short-circuit defect of the display device 30.

The first element insulating layer PDL1 may include an inorganic insulating material. As an example, the first element insulating layer PDL1 may include at least one of silicon nitride, silicon oxide, and silicon oxynitride.

The second element insulating layer PDL2 included in the display device 30 may be located on the first element insulating layer PDL1. The second element insulating layer PDL2 may define the emission opening OP3, and may expose the anode electrode AE in the portion overlapping the emission opening OP3. In other words, the second element insulating layer PDL2 may surround the emission opening OP3, and may cover an edge of the anode electrode AE. The second element insulating layer PDL2 may overlap the tip tip of the third bank layer BN3 in the third direction DR3.

The second element insulating layer PDL2 may include an inorganic insulating material. As an example, the second element insulating layer PDL2 may include at least one of silicon nitride, silicon oxide, and silicon oxynitride.

The light emitting element ED included in the display device 30 may be located on the element insulating layer PDL. The light emitting element ED may overlap the bank structure BN in the third direction DR3. In the display device 30, by forming the light emitting elements ED on the bank structure BN, it is possible to implement a high-resolution display device in which a gap between the light emitting elements ED is small. An overlapping description is omitted.

The light emitting element ED and the element inorganic layer IO included in the display device 30 may have the same structures and characteristics as the light emitting element ED and the element inorganic layer IO included in the display device 10. Other overlapping descriptions are omitted.

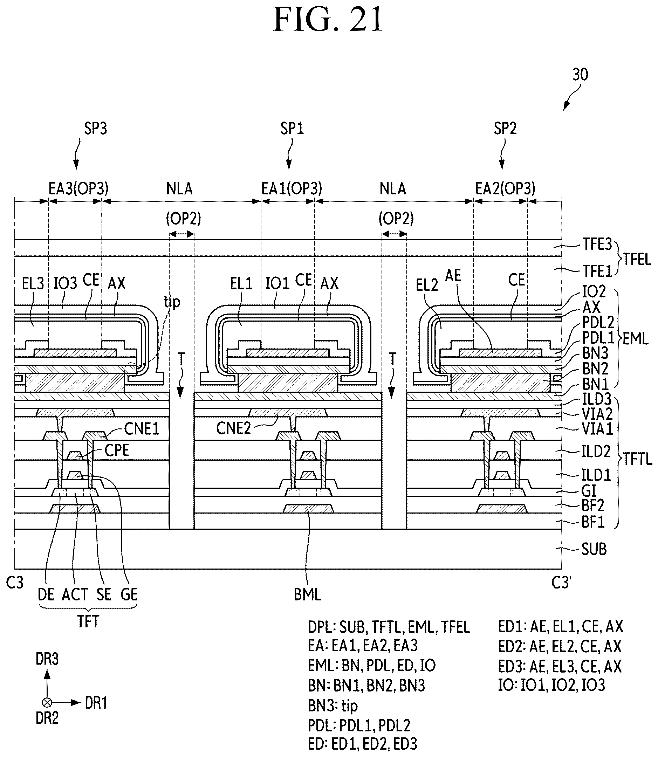

FIG. 21 is a cross-sectional view of an example of a display layer DPL taken along line C3-C3' of FIG. 19. A cross-sectional structure of the first sub-pixel SP1, the second sub-pixel SP2, and the third sub-pixel SP3 overlapping the emission openings OP3 and the non-emission opening OP2 in the portion overlapping the display area DDA of the display device 30 has been illustrated in FIG. 21.

Referring to FIG. 21 in addition to FIGS. 1 to 20, the display device 30 according to an embodiment may include the non-emission openings OP2 in a portion overlapping the non-emission area NLA. The non-emission openings OP2 may be defined by trench portions T.

The bank structure BN, the element insulating layer PDL, the light emitting element ED, and the element inorganic layer IO included in the display element layer EML of the display device 30 may be located in the portion overlapping the emission area EA, the emission opening OP3, or the anode contact hole ACTH, and may not overlap the non-emission opening OP2.

The trench portion T of the display device 30 may be formed to penetrate through the transistor layer TFTL. An overlapping description is omitted.

In addition, the trench portion T of the display device 30 may be formed to penetrate through the display element layer EML. As an example, the trench portion T may be formed to penetrate through the first bank layer BN1. Accordingly, the first bank layer BN1 may surround the trench portion T. An overlapping description is omitted.

Accordingly, in an embodiment, by forming the bank structure BN, the light emitting element ED, the element insulating layer PDL, and the element inorganic layer IO in the portion overlapping the emission area EA to which physical force due to bending and a form change is not applied and forming the trench portion T in the portion overlapping the non-emission area NLA to which the physical force due to the bending and the form change is repeatedly applied, it is possible to provide the display device 30 physically robust against bending stress.

In addition, in the display device 30 according to an embodiment, by forming the first to third light emitting elements ED1, ED2, and ED3 and the first to third element inorganic layers IO1, IO2, and IO3 on the respective bank structures BN overlapping the first to third emission areas EA1, EA2, and EA3, it is possible to solve a reliability defect caused by permeation of external moisture or oxygen even though the display device 30 includes the trench portion T.

The organic encapsulation layer TFE1 of the display device 30 may be located on the substrate SUB so as to be in contact with the substrate SUB in a portion overlapping the non-emission opening OP2.

A side surface of the first buffer layer BF1, a side surface of the second buffer layer BF2, a side surface of the gate insulating layer GI, a side surface of the first insulating layer ILD1, a side surface of the second insulating layer ILD2, a side surface of the first via layer VIA1, a side surface of the second via layer VIA2, a side surface of the third insulating layer ILD3, and a side surface of the first bank layer BN1 located in a direction toward the trench portion T may have various shapes depending on materials included in such layers and a fabricating method performed. Other overlapping descriptions are omitted.

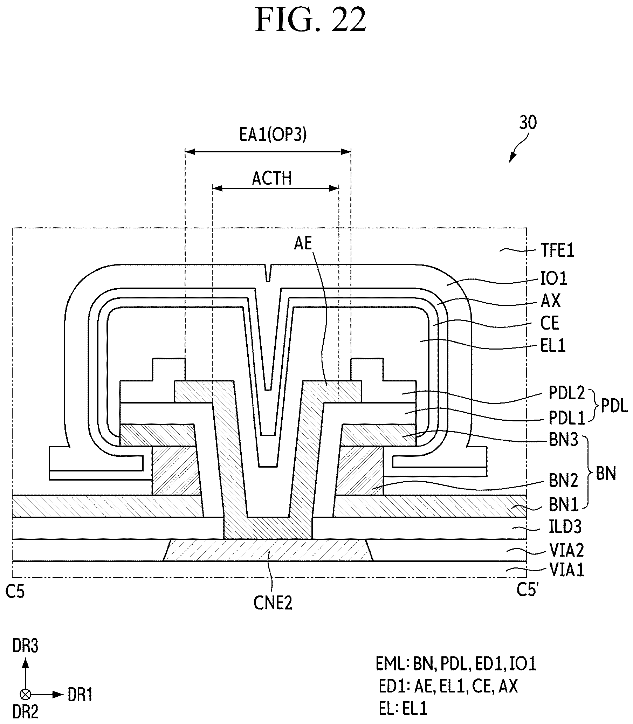

FIG. 22 is a cross-sectional view of an example of a display layer DPL taken along line C5-C5' of FIG. 19. A cross-sectional structure of the display element layer EML of the first sub-pixel SP1 overlapping the anode contact hole ACTH of the display device 30 has been illustrated in FIG. 21.

Referring to FIG. 22 in addition to FIGS. 1 to 21, the anode contact hole ACTH included in the display device 30 may be formed to overlap the emission area EA. However, the anode contact hole ACTH included in the display device 30 is different from the anode contact hole ACTH included in the display device 10 in that it is not formed integrally with the emission area EA and is located separately on one side of the emission area EA.

The anode contact hole ACTH included in the display device 30 may be located in the portion overlapping the emission opening OP3 defined by the second element insulating layer PDL2. The anode contact hole ACTH may be formed to penetrate through the bank structure BN and the third insulating layer ILD3, and the second connection electrode CNE2 overlapping the anode contact hole ACTH may be exposed.

The first bank layer BN1, the second bank layer BN2, and the third bank layer BN3 included in the display device 30 may surround the anode contact hole ACTH. A side surface of the first bank layer BN1, a side surface of the second bank layer BN2, and a side surface of the third bank layer BN3 facing the anode contact hole ACTH may be located on the same line.

The anode electrode AE included in the display device 30 may be spaced apart from the first bank layer BN1, the second bank layer BN2, and the third bank layer BN3 with the first element insulating layer PDL1 disposed between the anode electrode AE and the first bank layer BN1, the second bank layer BN2, and the third bank layer BN3. The anode electrode AE included in the display device 30 may cover a step formed by the first element insulating layer PDL1. Accordingly, in the portion overlapping the anode contact hole ACTH, the anode electrode AE may include a step.

In the portion overlapping the anode contact hole ACTH, the anode electrode AE and the second connection electrode CNE2 may be in contact with each other, and may be electrically connected to each other.

The light emitting layer EL included in the display device 30 may cover a step formed by the anode electrode AE in the portion overlapping the anode contact hole ACTH. Accordingly, the light emitting layer EL included in the display device 30 may include a step in the portion overlapping the anode contact hole ACTH.

The cathode electrode CE included in the display device 30 may cover the step formed by the anode electrode AE in the portion overlapping the anode contact hole ACTH. Accordingly, the cathode electrode CE included in the display device 30 may include a step in the portion overlapping the anode contact hole ACTH.

The auxiliary electrode AX included in the display device 30 may cover the step formed by the anode electrode AE in the portion overlapping the anode contact hole ACTH. Accordingly, the auxiliary electrode AX included in the display device 30 may include a step in the portion overlapping the anode contact hole ACTH.

The first element inorganic layer IO1 included in the display device 30 may cover the step formed by the anode electrode AE in the portion overlapping the anode contact hole ACTH. Accordingly, the first element inorganic layer IO1 included in the display device 30 may include a step in the portion overlapping the anode contact hole ACTH. However, the present disclosure is not limited thereto, and the first element inorganic layer IO1 may not include the step in the portion overlapping the anode contact hole ACTH. Other overlapping descriptions are omitted.

According to one or more embodiment, a display area DDA of a display device 10 or 30 includes insulating layers (like BF1 through ILD3) of a transistor layer TFTL on a substrate SUB, and a display element layer EML electrically connected to the transistor layer TFTL. The display element layer includes a bank (BN1, BN2 and BN3) in which a bank opening (corresponding to emission openings OP2) in a non-emission area NLA and an anode contact hole ACTH in an emission area EA are defined, the bank having an overhang structure at the bank opening and a side surface which defines the anode contact hole ACTH, an element insulating layer (PDL1) in the anode contact hole ACTH and covering the side surface of the bank, a light emitting element on the element insulating layer, and a trench which is in the non-emission area NLA and adjacent to the light emitting element. The trench penetrates through the bank of the display element layer EML and the insulating layers of the transistor layer to expose the substrate SUB to the trench.

Within the bank structure BN, a third bank layer BN3 is on the second bank layer BN2 and has a tip of the overhang structure which protrudes further than an outer side surface of the second bank layer BN2. The first bank layer BN1, the second bank layer BN2 and the third bank layer BN3 may together define the anode contact hole ACTH.

The emission area may be provided in plural including a first emission area EA1 and a second emission area EA2 adjacent to each other with the trench therebetween, the light emitting element may be provided in plural including a first light emitting element ED1 overlapping the first emission area EA1 and a second light emitting element ED2 overlapping the second emission area EA2, the third bank layer BN3 may be provided in plural spaced apart from each other and respectively surrounding the anode contact hole ACTH at the first emission area EA1 and the second emission area EA2, and the third bank layer BN3 surrounding the first emission area EA1 and the third bank layer BN3 surrounding the second emission area EA2 may be connected to each other by the first bank layer BN1.

In an embodiment, the light emitting element may further include an element inorganic layer IO which is on the auxiliary electrode AX and non-overlapping the trench.

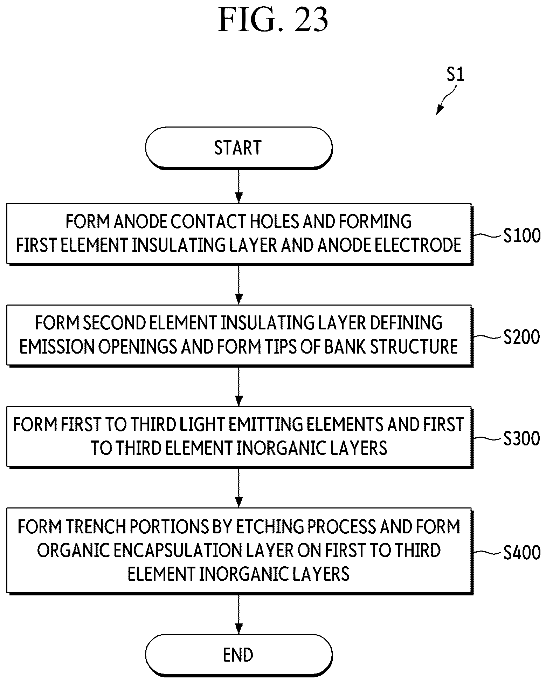

FIG. 23 is a flowchart illustrating a method for fabricating (or providing) the display layer of FIG. 16.

Referring to FIG. 23 in addition to FIGS. 1 to 22, a method (S1) for fabricating the display layer DPL included in the display device 10 according to an embodiment may include forming (or providing) anode contact holes penetrating through a bank structure to provide second bank openings and forming a first element insulating layer and an anode electrode (S100), forming a second element insulating layer defining emission openings and forming tips of the bank structure at first bank openings (S200), forming first to third light emitting elements and first to third element inorganic layers (S300), and forming trench portions by an etching process and forming an organic encapsulation layer on the first to third element inorganic layers (S400).

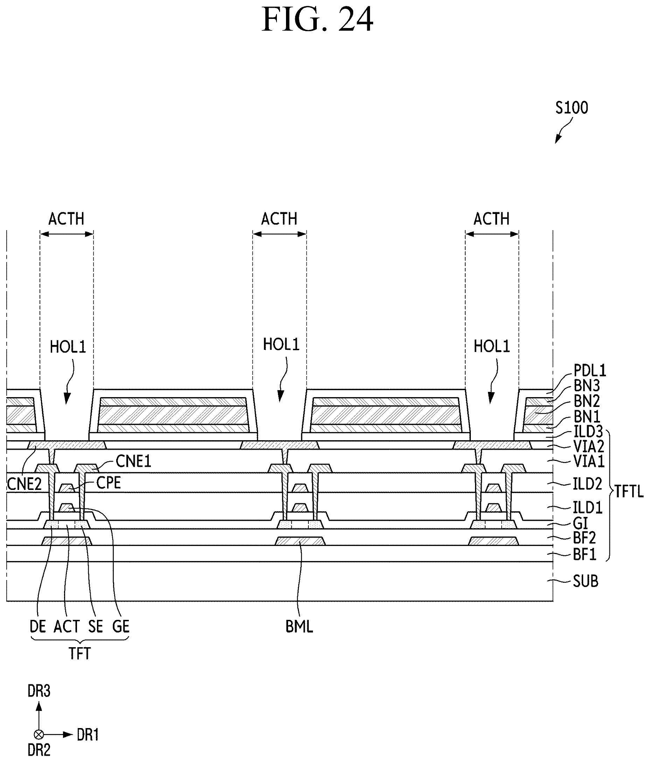

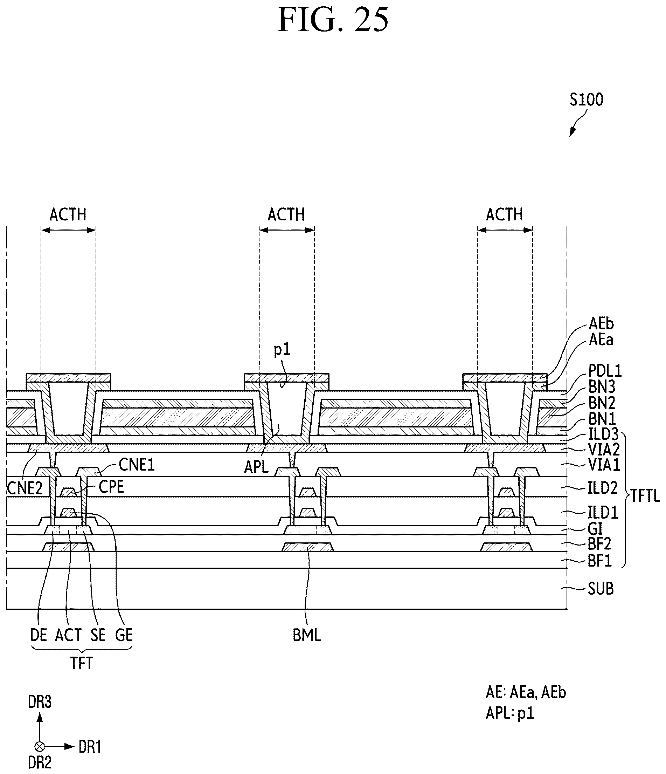

FIGS. 24 and 25 are cross-sectional views for describing S100 of FIG. 23.

The forming of the anode contact holes penetrating through the bank structure and the forming of the first element insulating layer and the anode electrode (S100) is described with reference to FIGS. 24 and 25. Hereinafter, a description of a fabricating process of the transistor layer TFTL located on the substrate SUB will be omitted, and a fabricating process of the display element layer EML will be described in detail.

First, a plurality of second connection electrodes CNE2 are formed on the first via layer VIA1 of the transistor layer TFTL, and the second via layer VIA2, the third insulating layer ILD3, and the bank structure BN are formed.

In the present process, the bank structure BN may include a first bank layer BN1, a second bank layer BN2, and a third bank layer BN3 which are sequentially stacked. In an embodiment, the second bank layer BN2 and the third bank layer BN3 may include different materials. As an example, the third bank layer BN3 may include a material having higher etching resistance than the second bank layer BN2. An overlapping description is omitted.

In the present process, the first bank layer BN1, the second bank layer BN2, and the third bank layer BN3 as preliminary bank (material) layers may be entirely formed on the third insulating layer ILD3 and then partially removed by a subsequent etching process. Accordingly, holes HOL1 as the second bank openings may be formed, and respective materials of the first bank layer BN1, the second bank layer BN2, and the third bank layer BN3 may surround the holes HOL1.

In the present process, a side surface of the first bank layer BN1, a side surface of the second bank layer BN2, and a side surface of the third bank layer BN3 which face the hole HOL1 may be located on the same line, and the third insulating layer ILD3 overlapping the hole HOL1 may be exposed.

Subsequently, the first element insulating layer PDL1 is formed on the bank structure BN and within the second bank openings. The first element insulating layer PDL1 may be formed through a film forming process (e.g., a deposition process) of forming at least one of the inorganic materials described above and a patterning process.

In the present process, the first element insulating layer PDL1 may be temporarily formed entirely on the bank structure BN and the third insulating layer ILD3, and then portions of the first element insulating layer PDL1 overlapping the holes HOL1 may be removed through a patterning process. Accordingly, the second connection electrode CNE2 may be exposed to outside the first element insulating layer PDL1 and the third insulating layer ILD3 in a portion overlapping the hole HOL1, and the first element insulating layer PDL1 may entirely cover the side surface of the first bank layer BN1, the side surface of the second bank layer BN2, and the side surface of the third bank layer BN3 which face the hole HOL1.

Next, as illustrated in FIG. 25, the anode electrode AE is formed on the first element insulating layer PDL1.

First, the first conductive layer AEa of the anode electrode AE is formed. The first conductive layer AEa may be formed through a film forming process (e.g., a sputtering process) of forming at least one of the metal materials described above and a patterning process.

In the present process, the first conductive layer AEa may be temporarily formed entirely on the first element insulating layer PDL1 and the second connection electrodes CNE2, and then patterned in a form illustrated in FIG. 25 through a subsequent etching process. The first conductive layer AEa may be spaced apart from the bank structure BN by the first element insulating layer PDL1.

Next, the anode planarization layer APL is formed on the first conductive layer AEa.

In the present process, the anode planarization layer APL may be formed by performing a film forming process (e.g., a sputtering process) of forming at least one of the metal materials described above and a chemical mechanical polishing (CMP) process. As an example, the CMP process refers to a process of polishing and planarizing a surface having irregularities or bends through chemical/mechanical elements.

Through the present process, a portion of the anode planarization layer APL may be polished and removed, and the anode planarization layer APL may have a first surface p1 in a portion overlapping the anode contact hole ACTH. The first surface p1 of the anode planarization layer APL may have a surface polished by the CMP process.

Through this process, the anode planarization layer APL may planarize a step formed by the first conductive layer AEa in the portion overlapping the anode contact hole ACTH.

Next, the second conductive layer AEb of the anode electrode AE is formed on the first conductive layer AEa and the anode planarization layer APL.

In the present process, the second conductive layer AEb may be formed through a film forming process (e.g., a sputtering process) of forming at least one of the metal materials described above.

In the present process, the second conductive layer AEb may be temporarily formed entirely on the first conductive layer AEa and the anode planarization layer APL, and then patterned in a form illustrated in FIG. 25 by a subsequent etching process.

In the present process, the anode planarization layer APL may be completely surrounded by the first conductive layer AEa and the second conductive layer AEb.

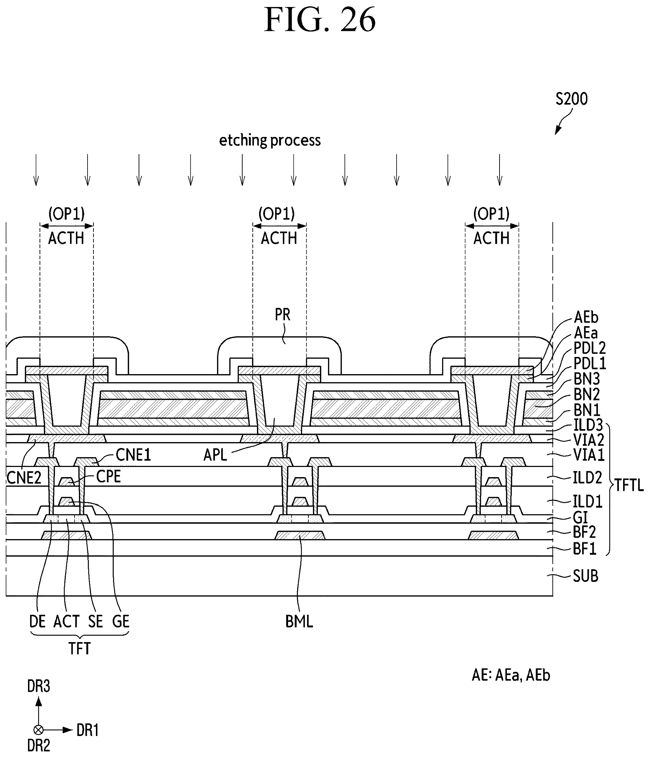

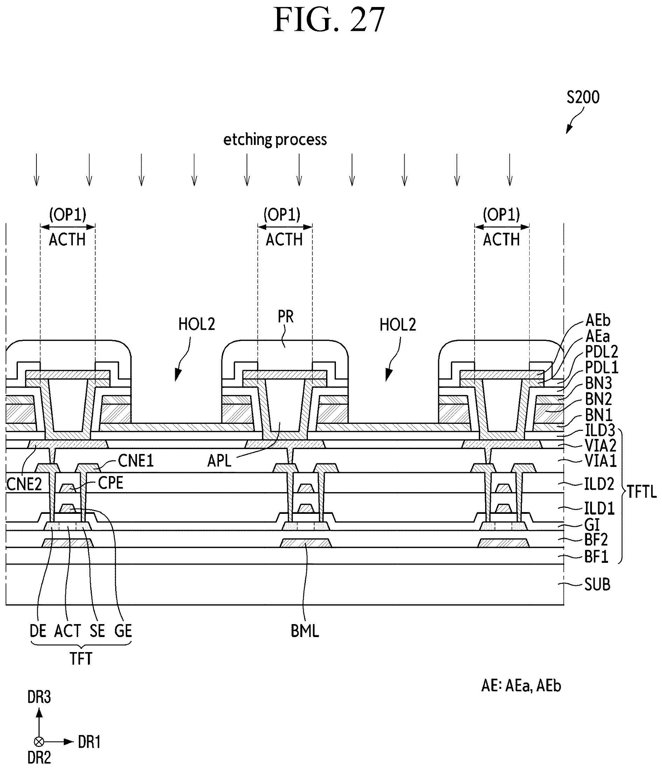

FIGS. 26 to 28 are cross-sectional views for describing S200 of FIG. 23.

The forming of the second element insulating layer defining the emission openings and the forming of the tips of the bank structure (S200) is described with reference to FIGS. 26 to 28.

First, the second element insulating layer PDL2 defining the emission openings OP1 is formed on the anode electrode AE and the first element insulating layer PDL1.

In the present process, the second element insulating layer PDL2 may be temporarily formed to entirely cover the anode electrode AE, and portions of the second element insulating layer PDL2 may be then removed through a subsequent etching process to form the emission openings OP1. The second element insulating layer PDL2 may surround the emission openings OP1, and the second conductive layer AEb of the anode electrode AE may be exposed in portions overlapping the emission openings OP1.

It has been illustrated in FIGS. 26 to 28 that a width of the anode contact hole ACTH and a width of the emission opening OP1 in the first direction DR1 are the same as each other, but the present disclosure is not limited thereto. The anode contact hole ACTH and the emission opening OP1 may overlap each other in the third direction DR3, but the width of the anode contact hole ACTH and the width of the emission opening OP1 may be different from each other.

Subsequently, photoresists PR are formed on the anode electrode AE and the second element insulating layer PDL2, and an etching process is performed. The photoresists PR may correspond to an area of the final stacked structure of the display elements. In the present process, a plurality of photoresists PR may be formed, and may be located in portions overlapping the anode contact holes ACTH or the emission openings OP1. In the present process, a dry etching process and a wet etching process may be sequentially performed as the etching process.

First, the dry etching process is performed. As an example, the dry etching process may be performed through a reactive ion etching (RIE) process using a reaction gas such as CHF₃, CH₃F, CH₂F₂, CHF₆, CF₄, C₂F₆, or C₃F₆, and a sputtering gas such as Ar or O₂/Ar. In this case, an inductively coupled plasma (ICP) source or a capacitively coupled plasma (CCP) source may be used as a plasma source.

In the present process, the second element insulating layer PDL2, the first element insulating layer PDL1, the second bank layer BN2, and the third bank layer BN3 which do not overlap the photoresists PR may be removed at once, and for this reason, holes HOL2 may be formed. The hole HOL2 as a first bank opening may be formed in a portion which does not overlap the anode contact hole ACTH, and a side surface of the second element insulating layer PDL2, a side surface of the first element insulating layer PDL1, a side surface of the second bank layer BN2, and a side surface of the third bank layer BN3 which face the hole HOL2 may be located on the same line. In other words, in the present process, an anisotropic etching process may be performed as the etching process.

In the present process, the first bank layer BN1 overlapping the hole HOL2 may be exposed to outside the bank structure BN.

Next, the wet etching process is performed. As an example, the wet etching process may be performed using a liquid chemical solution such as a diluted hydrofluoric acid solution, a nitric acid solution, a tetramethylammonium hydroxide solution, or a potassium hydroxide solution.

In the present process, the second bank layer BN2 and the third bank layer BN3 including different metal materials may have different etching selectivities. Specifically, in the same etching process, the third bank layer BN3 may have higher etching resistance than the second bank layer BN2. In other words, in the same etching process, the second bank layer BN2 may include a material having a higher etching rate than the third bank layer BN3.

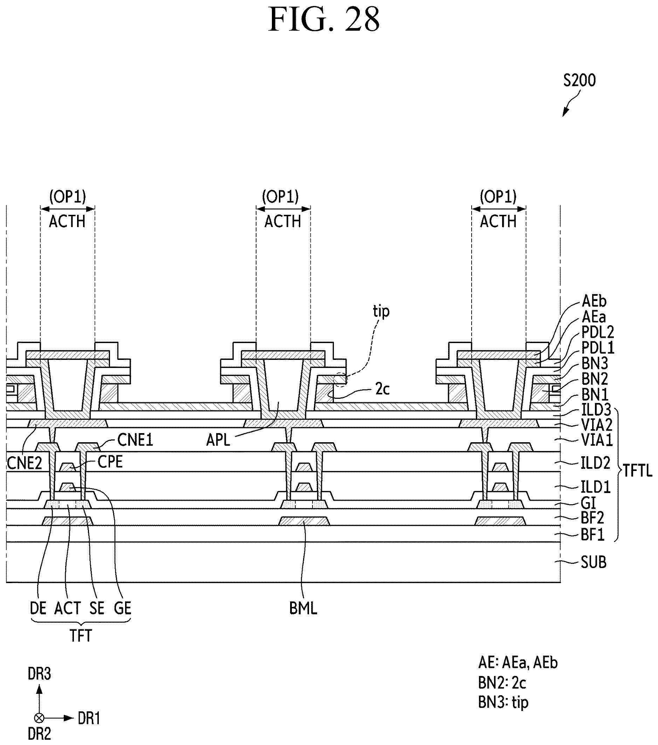

Accordingly, as illustrated in FIG. 28, the third bank layer BN3 may include a tip tip protruding more than a first side surface 2c of the second bank layer BN2 in the first direction DR1. The first element insulating layer PDL1 and the second element insulating layer PDL2 may overlap the tip tip of the third bank layer BN3 in the third direction DR3. An overlapping description is omitted.

Although not illustrated in FIG. 28, the photoresists PR may be removed through an ashing process.

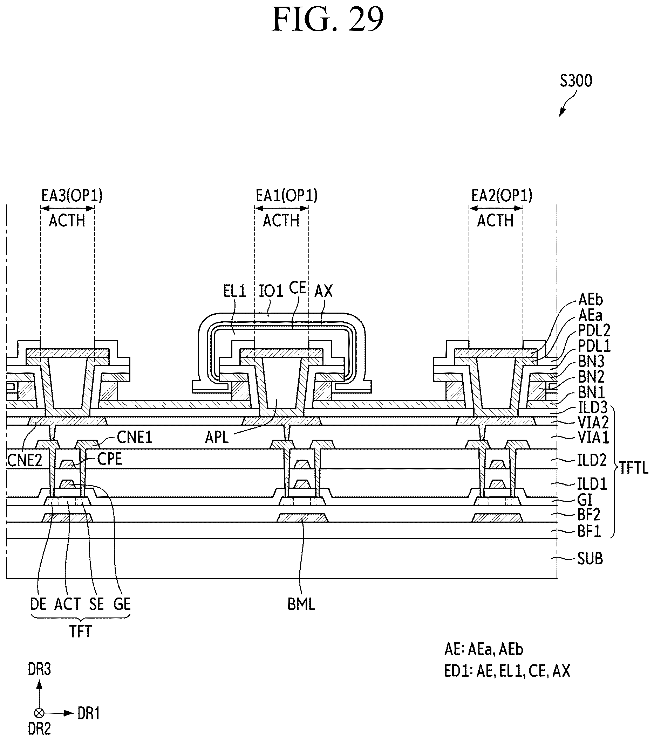

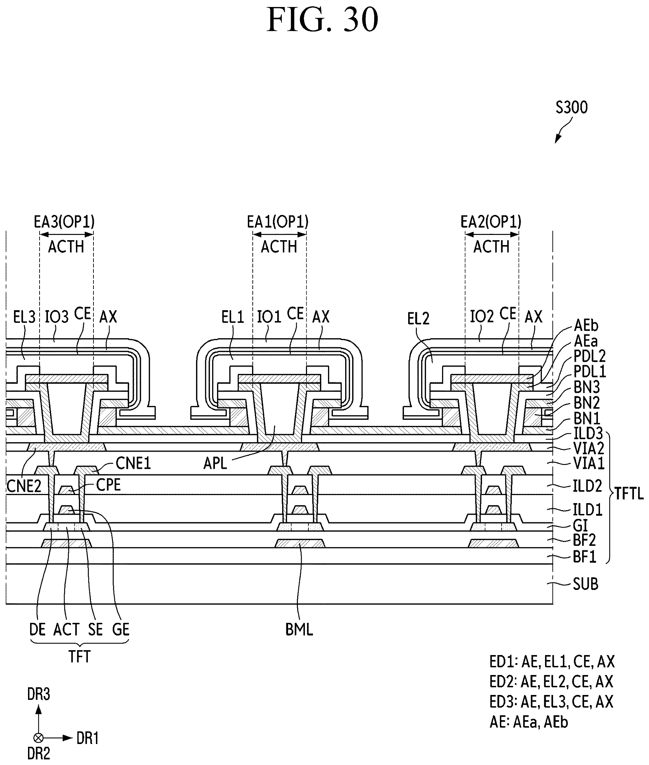

FIGS. 29 and 30 are cross-sectional views for describing S300 of FIG. 23.

The forming of the first to third light emitting elements and the first to third element inorganic layers (S300) is described with reference to FIGS. 29 and 30.

Subsequently, the first light emitting element ED1 is formed by depositing the first light emitting layer EL1, the cathode electrode CE, and the auxiliary electrode AX on the anode electrode AE.

In the present process, a process of forming the first light emitting layer EL1 may be performed through a thermal deposition process. In the present process, a material forming the first light emitting layer EL1 may not only be temporarily formed on the anode electrode AE overlapping the first emission area EA1, but may also be formed on the anode electrodes AE located in portions overlapping the second emission area EA2 and the third emission area EA3 and be formed on the first bank layer BN1. The material forming the first light emitting layer EL1, located on the anode electrode AE and the material forming the first light emitting layer EL1, located on the first bank layer BN1 may be spaced apart from each other.

Thereafter, the material forming the first light emitting layer EL1 may be formed in a form illustrated in FIG. 29 by a subsequent etching process.

In the present process, a process of forming the cathode electrode CE may be performed through a thermal deposition process or a sputtering process. The process of forming the cathode electrode CE may have higher step coverage characteristic than the process of forming the first light emitting layer EL1. Accordingly, the cathode electrode CE may entirely cover the first light emitting layer EL1.

In the present process, a material forming the cathode electrode CE may not only be temporarily formed on the first light emitting layer EL1 overlapping the first emission area EA1, but may also be formed on the first light emitting layers EL1 located in the portions overlapping the second emission area EA2 and the third emission area EA3 and be formed on the first bank layer BN1.

Thereafter, the material forming the cathode electrode CE may be formed in a form illustrated in FIG. 29 by a subsequent etching process. The cathode electrode CE may be in contact with the tip tip of the third bank layer BN3. An overlapping description is omitted.

A process of forming the auxiliary electrode AX may be performed through a sputtering process. The process of forming the auxiliary electrode AX may have higher step coverage characteristics than the process of forming the cathode electrode CE. Accordingly, a material forming the auxiliary electrode AX may temporarily cover all of the cathode electrodes CE located in portions overlapping the first emission area EA1, the second emission area EA2, and the third emission area EA3.

Thereafter, the material forming the auxiliary electrode AX may be formed in a form illustrated in FIG. 29 by a subsequent etching process. The material forming the auxiliary electrode AX may be in contact with the tip tip of the third bank layer BN3 and the first side surface 2c of the second bank layer BN2. An overlapping description is omitted.

Subsequently, the element inorganic layer IO is formed on the auxiliary electrode AX. The element inorganic layer IO may cover an underlying structure at a uniform thickness along a profile of the underlying structure, and may entirely cover the auxiliary electrode AX. Accordingly, a material forming the element inorganic layer IO may temporarily cover all of the auxiliary electrodes AX located in the portions overlapping the first emission area EA1, the second emission area EA2, and the third emission area EA3.

In the present process, the element inorganic layer IO may be formed through a film forming process (e.g., a deposition process) of forming at least one of the inorganic materials described above.

Thereafter, the material forming the element inorganic layer IO may be formed in a form illustrated in FIG. 29 by a subsequent etching process. Consequently, the first light emitting element ED1 and the first element inorganic layer IO1 located in the portion overlapping the first emission area EA1 may be formed. Here, a final stacked structure of a first display element may include layers AEa through IO1 at the first emission area EA1.

Subsequently, the second light emitting layer EL2, the cathode electrode CE, the auxiliary electrode AX, and the element inorganic layer IO are formed on the anode electrode AE overlapping the second emission area EA2 by repeating the above-described processes. Through the present process, the second light emitting element ED2 and the second element inorganic layer IO2 overlapping the second emission area EA2 may be formed. Here, a final stacked structure of a second display element may include layers AEa through IO2 at the second emission area EA2.

In addition, the third light emitting layer EL3, the cathode electrode CE, the auxiliary electrode AX, and the element inorganic layer IO are formed on the anode electrode AE overlapping the third emission area EA3 by repeating the above-described processes again. Through the present process, the third light emitting element ED3 and the third element inorganic layer IO3 overlapping the third emission area EA3 may be formed. Here, a final stacked structure of a third display element may include layers AEa through IO3 at the third emission area EA3.

FIG. 30 represents extended portions of the layers BF1 through BN1 which are on the substrate SUB and extend from the emission areas and into the non-emission area NLA. Such extended portions may remain extended between adjacent emission areas, such as along A1-A1' (FIG. 12) or C1-C1' (FIG. 19). Others of the extended portions may be removed to form trenches, such as along A3-A3' (FIG. 12) or C3-C3' (FIG. 19).

In the display device 10 according to an embodiment, the third bank layer BN3 includes the tip tip, and accordingly, the first light emitting layer EL1, the second light emitting layer EL2, and the third light emitting layer EL3 spaced apart from each other may be formed in the portions overlapping the first to third emission areas EA1, EA2, and EA3 without a separate fine metal mask.

In addition, in the display device 10 according to an embodiment, the third bank layer BN3 includes the tip tip, and accordingly, the cathode electrodes CE spaced apart from each other may be formed in the portions overlapping the first to third emission areas EA1, EA2, and EA3 without a separate fine metal mask. Accordingly, the display device 10 according to an embodiment may have fabrication easiness.

In addition, the display device 10 according to an embodiment includes the anode planarization layer APL filling the anode contact hole ACTH in the portion overlapping the anode contact hole ACTH, and thus, the step included in the first conductive layer AEa may be planarized. Accordingly, the second conductive layer AEb of the anode electrode AE may be formed to have one surface which is flat, and for this reason, the first to third light emitting layers EL1, EL2, and EL3 may be formed at a uniform thickness. Accordingly, a reliability defect (e.g., a light emitting layer shadow defect) of the display device 10 may be solved. Other overlapping descriptions are omitted.

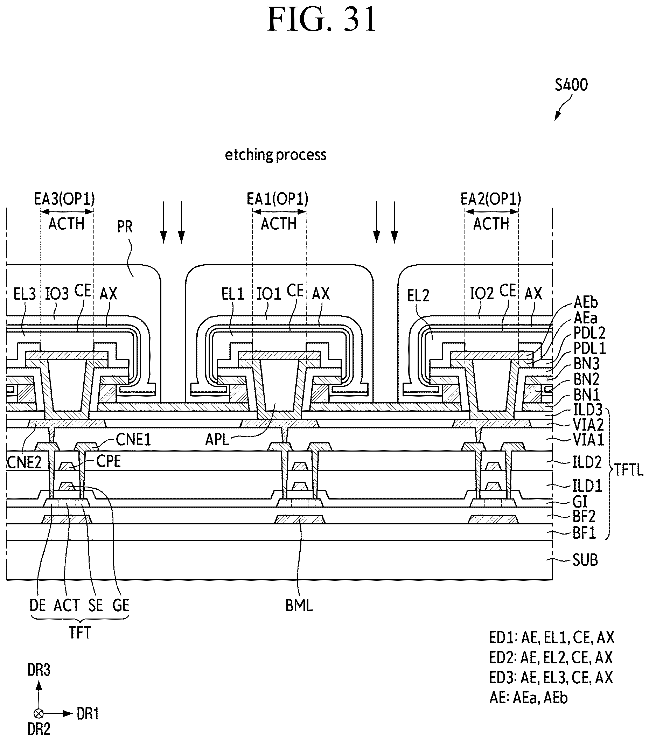

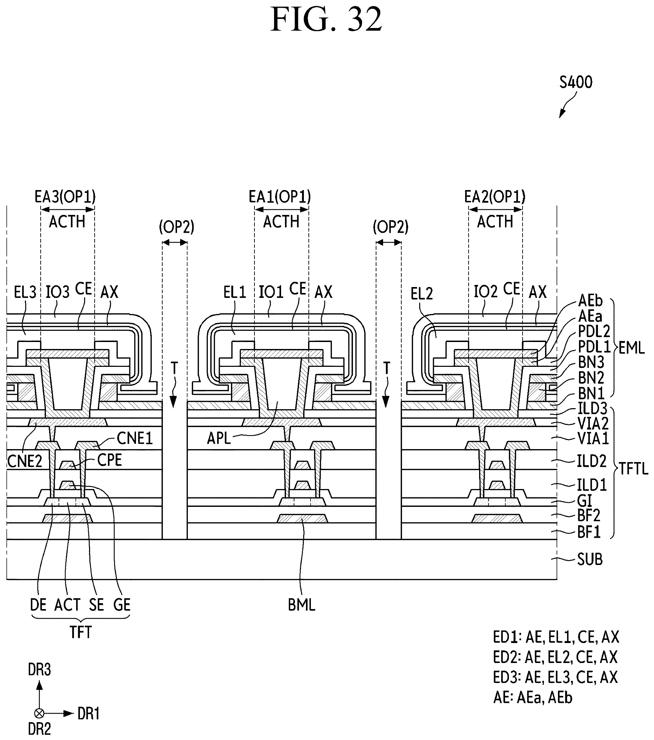

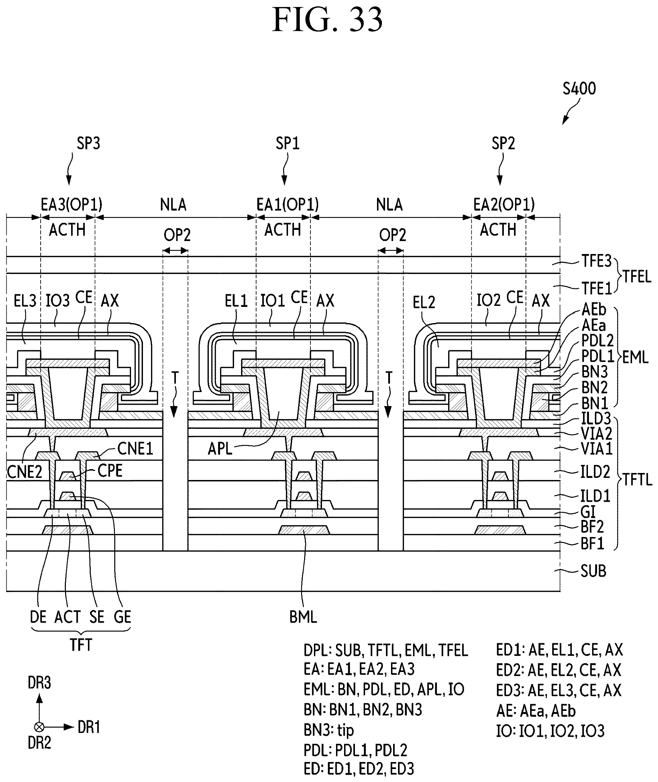

FIGS. 31 to 33 are cross-sectional views for describing S400 of FIG. 23.

The forming of the trench portions T by the etching process and the forming of the organic encapsulation layer on the first to third element inorganic layers (S400) is described with reference to FIGS. 31 to 33.

First, photoresists PR completely covering each of the first element inorganic layer IO1, the second element inorganic layer IO2, and the third element inorganic layer IO3 are formed. Such photoresists PR may correspond to a total planar area of the stacked structure (e.g., BF1 through IO) defining the respective display elements. In the present process, the respective photoresists PR located in the portions overlapping the first to third emission areas EA1, EA2, and EA3 may be spaced apart from each other while exposing the first bank layer BN1.

Subsequently, an etching process is performed. As an example, the etching process may be performed through at least one of a dry etching process or a wet etching process. An overlapping description is omitted.

In the present process, extended portions of the first buffer layer BF1, the second buffer layer BF2, the gate insulating layer GI, the first insulating layer ILD1, the second insulating layer ILD2, the first via layer VIA1, the second via layer VIA2, and the third insulating layer ILD3 of the transistor layer TFTL and the first bank layer BN1 included in the display element layer EML which do not overlap the photoresists PR may be removed at once. Accordingly, the trench portions T may be formed, and the substrate SUB may be exposed to outside the display element stacked structures at portions overlapping the trench portions T.

In other words, the trench portions T may be formed to penetrate completely through thicknesses of the first buffer layer BF1, the second buffer layer BF2, the gate insulating layer GI, the first insulating layer ILD1, the second insulating layer ILD2, the first via layer VIA1, the second via layer VIA2, and the third insulating layer ILD3 included in the transistor layer TFTL and the first bank layer BN1 included in the display element layer EML, and may define the non-emission openings OP2. Such non-emission openings may overlap the first bank openings which are defined in the bank structure BN.

Next, the organic encapsulation layer TFE1 is formed. The organic encapsulation layer TFE1 may be formed through an applying process of forming at least one of the organic materials described above.

In the present process, the organic encapsulation layer TFE1 may include a material which temporarily has flowability, and accordingly, may completely fill the trench portions T. In addition, in the present process, the organic encapsulation layer TFE1 may also fill a gap space between the auxiliary electrode AX and the first bank layer BN1.

Thereafter, the organic encapsulation layer TFE1 is cured through a subsequent curing process. In the present process, the organic encapsulation layer TFE1 filling the trench portion T and the organic encapsulation layer TFE1 filling the spaced space between the auxiliary electrode AX and the first bank layer BN1 may be formed integrally with each other.

Next, the inorganic encapsulation layer TFE3 may be formed on the organic encapsulation layer TFE1.

In the present process, the inorganic encapsulation layer TFE3 may be formed through a deposition process of forming at least one of the inorganic insulating materials described above.

Consequently, the display layer DPL of FIG. 16 may be formed.

The display device 10 according to an embodiment includes a plurality of conductive layers of the transistor layer TFTL and the bank structure BN, the light emitting element ED, the element insulating layer PDL, the anode planarization layer APL, and the element inorganic layer IO of the display element layer EML in a portion overlapping the emission area EA, and thus, the trench portions T may be formed at once through one etching process. Accordingly, the display device 10 according to an embodiment may have fabrication easiness.

In an embodiment, a method for providing a display device 10 or 30 includes providing a substrate SUB including a display area DDA having an emission area EA and a non-emission area NLA, and a non-display area NDA which is adjacent to the display area DDA, and in the display area DDA, providing a transistor layer TFTL on the substrate SUB and including insulating layers (like BF1 through ILD3), and a display element layer EML which is on the transistor layer TFTL and electrically connected to the transistor layer TFTL.

The providing of the display element layer EML includes providing a bank structure BN on the transistor layer TFTL and in which bank openings (holes HOL2) in the non-emission area NLA and anode contact holes ACTH in the emission area EA are defined, the bank structure BN having an overhang structure (e.g., tip (structure tip) at the bank openings and a side surface which defines the anode contact holes ACTH, providing an element insulating layer (e.g., PDL1 and PDL2) in which emission openings (OP1 or OP3) are defined overlapping the anode contact holes ACTH, respectively, providing light emitting elements respectively in the emission openings and electrically connected to the transistor layer TFTL, the light emitting elements spaced apart from each other along the substrate SUB.

In the non-emission area NLA which is between the light emitting elements, the method includes etching through the bank structure BN of the display element layer EML and the insulating layers of the transistor layer TFTL to provide both a trench (e.g., trench portion T) which exposes the substrate SUB to outside both the insulating layers and the display element layer EML, and an extended portion of the bank structure BN which electrically connects the light emitting elements to each other.

Referring to FIG. 12, in the first direction DR1 or the second direction DR2 between patterns of the third bank layer BN3 which are adjacent to each other, there is both portions of a non-emission opening OP2 (e.g., the trench) and the first bank layer BN1. That is, to provide a robust deformable structure at the non-emission area NLA where physical (bending and/or stretching) stresses are applied, a trench extends through a stacked structure at positions between light emitting elements, together with an extended portion of a bank structure (at BN1) providing the light emitting elements electrically connected to each other.

In an embodiment, the insulating layers of the transistor layer TFTL are in both the emission area EA and the non-emission area NLA of the display area DDA. The etching through the bank structure BN of the display element layer EML and the insulating layers of the transistor layer TFTL may further provide extended portions of the insulating layers which respectively connect insulating layer portions overlapping the light emitting elements to each other. For example, along lines A3-A3' and C3-C3' both the first bank layer BN1 and the underlying insulating layers have extended portions.

In an embodiment, an organic encapsulation layer TFE1 may be on the element inorganic layers IO of the first light emitting element ED1 and the second light emitting elements ED2. The organic encapsulation layer TFE1 may extend into the trench, fill the trench and contact the substrate SUB in the trench.

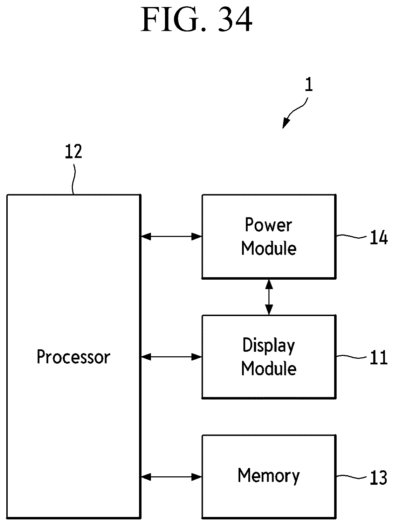

FIG. 34 is a block diagram of an electronic device 1 according to an embodiment.

Referring to FIG. 34 in addition to FIGS. 1 to 33, the display device 10 or 30 according to an embodiment may be applied to various electronic devices 1. The electronic device 1 according to an embodiment may include the display device 10 or 30 described above, and may further include a module or a device having an additional function in addition to the display device 10 or 30.

The electronic device 1 according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for an operation of the processor 12 or the display module 11. When the processor 12 executes an application stored in the memory 13, an image data signal and/or an input control signal may be transferred to the display module 11, and the display module 11 may process the received signal and output image information through a display screen.

The power module 14 may include a power supply module such as a power adapter or a battery device and a power conversion module converting power supplied by the power supply module to generate power necessary for an operation of the electronic device 1.

At least one of the respective components of the above-described electronic device 1 may be included in the display device according to the above-described embodiments. In addition, some of individual modules functionally included in one module may be included in the display device, and the others of the individual modules may be provided separately from the display device. For example, the display device may include the display module 11, and the processor 12, the memory 13, and the power module 14 may be provided in the form of other devices within the electronic device 1 rather than the display device.

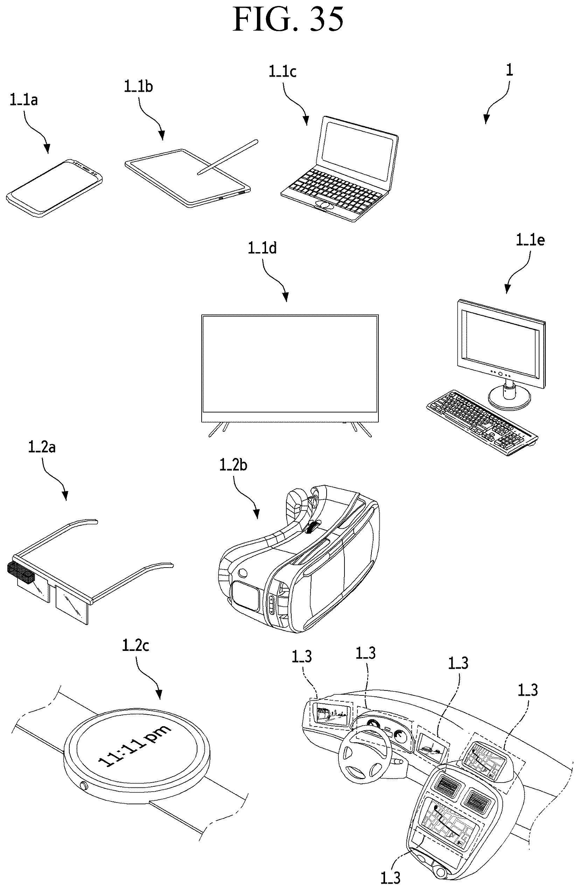

FIG. 35 is schematic views of electronic devices according to various embodiments.

Referring to FIG. 35 in addition to FIGS. 1 to 34, various electronic devices 1 to which the display devices 10 and 30 according to embodiments are applied may include not only image display electronic devices such as a smartphone 1_1a, a tablet PC 1_1b, a laptop computer 1_1c, a television (TV) 1_1d, and a monitor 1_1e for a desktop computer, but also wearable electronic devices including display modules, such as a smart glasses 1_2a, a head mounted display 1_2b, and a smart watch 1_2c, and vehicle electronic devices 1_3 including display modules, such as a center information display (CID) disposed on an instrument board, a center fascia, or a dashboard of a vehicle and a room mirror display.

Embodiments of the disclosure should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (10) comprising:
a substrate (SUB) including a display area (DDA) and a non-display area (NDA) which is adjacent to the display area (DDA); and
the display area (DDA) including:
an emission area (EA) and a non-emission area (NLA);
a transistor layer (TFTL) on the substrate (SUB) and including insulating layers; and
a display element layer (EML) which is electrically connected to the transistor layer (TFTL), the display element layer (EML) including:
a bank structure (BN) on the transistor layer (TFTL) and in which a bank opening in the non-emission area (NLA) and an anode contact hole (ACTH) in the emission area (EA) are defined, the bank structure (BN) having an overhang structure at the bank opening and a side surface which defines the anode contact hole (ACTH);
a first element insulating layer (PDL1) in the anode contact hole (ACTH) and covering the side surface of the bank structure (BN);
a light emitting element (ED) on the first element insulating layer (PDL1); and
a trench (T) which is in the non-emission area (NLA) and adjacent to the light emitting element (ED),
wherein the trench (T) penetrates through the bank structure (BN) of the display element layer (EML) and the insulating layers of the transistor layer (TFTL), the substrate (SUB) being exposed to the trench (T).

2. The display device (10) of claim 1, wherein the bank structure (BN) includes:
a first bank layer (BN1);
a second bank layer (BN2) on the first bank layer (BN1);
a third bank layer (BN3) on the second bank layer (BN2) and having a tip (tip) of the overhang structure which protrudes further than an outer side surface (2c) of the second bank layer (BN2); and
the first bank layer (BN1), the second bank layer (BN2) and the third bank layer (BN3) together defining the anode contact hole (ACTH).

3. The display device (10) of claim 2, wherein the trench (T) penetrates through the first bank layer (BN1), optionally

4. The display device (10) of claim 3, wherein the first bank layer (BN1) has a mesh shape.

5. The display device (10) of claim 4, wherein
the emission area (EA) is provided in plural including a first emission area (EA1) and a second emission area (EA2) adjacent to each other with the trench (T) therebetween;
the light emitting element (ED) is provided in plural including a first light emitting element (ED1) overlapping the first emission area (EA1) and a second light emitting element (ED2) overlapping the second emission area (EA2);
the third bank layer (BN3) is provided in plural spaced apart from each other and respectively surrounding the anode contact hole (ACTH) at the first emission area (EA1) and the second emission area (EA2); and
the third bank layer (BN3) surrounding the first emission area (EA1) and the third bank layer (BN3) surrounding the second emission area (EA2) are connected to each other by the first bank layer (BN1).

6. The display device (10) of any one of claims 2 to 4, further comprising a second element insulating layer (PDL2) on the first element insulating layer (PDL1) and defining an emission opening (OP1) corresponding to the anode contact hole (ACTH) in the bank structure (BN),
wherein the light emitting element (ED) includes:
a light emitting layer (EL1) on an anode electrode (AE) and entirely covering the second element insulating layer (PDL2);
a cathode electrode (CE) on the light emitting layer (EL1) and in contact with the overhang structure of the bank structure (BN) at the third bank layer (BN3); and
an auxiliary electrode (AX) on the cathode electrode (CE) and in contact with the outer side surface (2c) of the second bank layer (BN2).

7. The display device (10) of claim 6, wherein
the emission area (EA) is provided in plural including a first emission area (EA1) and a second emission area (EA2) adjacent to each other with the trench (T) therebetween;
the light emitting element (ED) is provide in plural including a first light emitting element (ED1) overlapping the first emission area (EA1) and a second light emitting element (ED2) overlapping the second emission area (EA2); and
the cathode electrode (CE) and the auxiliary electrode (AX) included in the first light emitting element (ED1) are spaced apart from the cathode electrode (CE) and the auxiliary electrode (AX) included in the second light emitting element (ED2) with the trench (T) defined between the cathode electrode (CE) and the auxiliary electrode (AX) included in the first light emitting element (ED1) and the cathode electrode (CE) and the auxiliary electrode (AX) included in the second light emitting element (ED2), respectively.

8. The display device (10) of claim 6, wherein
the anode electrode (AE) includes a first conductive layer (AEa) facing a second conductive layer (AEb) with an anode planarization layer (APL) therebetween;
the anode electrode (AE) together with the first element insulating layer (PDL1) fills the anode contact hole (ACTH) of the bank structure (BN);
the emission area (EA) is provided in plural including a first emission area (EA1) and a second emission area (EA2) adjacent to each other with the trench (T) therebetween;
the light emitting element (ED) is provide in plural including a first light emitting element (ED1) overlapping the first emission area (EA1) and a second light emitting element (ED2) overlapping the second emission area (EA2); and
the anode planarization layer (APL) of the first light emitting element (ED1) and the anode planarization layer (APL) of the second light emitting element (ED2) are spaced apart from each other with the trench (T) between the anode planarization layer (APL) of the first light emitting element (ED1) and the anode planarization layer (APL) of the second light emitting element (ED2).

9. The display device (10) of claim 6, wherein
the light emitting element (ED) further includes an element inorganic layer (IO) which is on the auxiliary electrode (AX) and non-overlapping the trench (T);
the emission area (EA) is provided in plural including a first emission area (EA1) and a second emission area (EA2) adjacent to each other with the trench (T) therebetween;
the light emitting element (ED) is provide in plural including a first light emitting element (ED1) overlapping the first emission area (EA1) and a second light emitting element (ED2) overlapping the second emission area (EA2);
the element inorganic layer (IO1) of the first light emitting element (ED1) and the element inorganic layer (IO2) of the second light emitting element (ED2) are spaced apart from each other with the trench (T) between the element inorganic layer (IO1) of the first light emitting element (ED1) and the element inorganic layer (IO2) of the second light emitting element (ED2).

10. The display device (10) of claim 9, further comprising an organic encapsulation layer (TFE1) on the element inorganic layers (IO1, IO2) of the first light emitting element (ED1) and the second light emitting elements (ED2),
wherein the organic encapsulation layer (TFE1) extends into the trench (T), fills the trench (T) and contacts the substrate (SUB) in the trench (T), optionally wherein side surfaces of the insulating layers of the transistor layer (TFTL) and a side surface of the first bank layer (BN1) together define the trench (T) and are entirely covered by the organic encapsulation layer (TFE1).

11. The display device (10) of any one of claims 1 to 10, wherein the substrate (SUB) includes polyimide.

12. A method for providing a display device (10), the method comprising:
providing a substrate (SUB) including a display area (DDA) having an emission area (EA) and a non-emission area (NLA), and a non-display area (NDA) which is adjacent to the display area (DDA); and
in the display area (DDA), providing:
a transistor layer (TFTL) on the substrate (SUB) and including insulating layers; and
a display element layer (EML) which is on the transistor layer (TFTL) and electrically connected to the transistor layer (TFTL),
wherein the providing of the display element layer (EML) includes:
providing a bank structure (BN) on the transistor layer (TFTL) and in which bank openings in the non-emission area (NLA) and anode contact holes (ACTH) in the emission area (EA) are defined, the bank structure (BN) having an overhang structure at the bank openings and a side surface which defines the anode contact holes (ACTH);
providing an element insulating layer (PDL) in which emission openings (OP1) are defined overlapping the anode contact holes (ACTH), respectively;
providing light emitting elements (ED) respectively in the emission openings (OP1) and electrically connected to the transistor layer (TFTL), the light emitting elements (ED) spaced apart from each other along the substrate (SUB); and
in the non-emission area (NLA) which is between the light emitting elements (ED), etching through the bank structure (BN) of the display element layer (EML) and the insulating layers of the transistor layer (TFTL) to provide both:
a trench (T) which exposes the substrate (SUB) to outside both the insulating layers and the display element layer (EML); and
an extended portion of the bank structure (BN) which electrically connects the light emitting elements (ED) to each other.

13. The method of claim 12, wherein
the insulating layers of the transistor layer (TFTL) are in both the emission area (EA) and the non-emission area (NLA) of the display area (DDA); and
the etching through the bank structure (BN) of the display element layer (EML) and the insulating layers of the transistor layer (TFTL) further provides extended portions of the insulating layers which respectively connect insulating layer portions overlapping the light emitting elements (ED) to each other, optionally further comprising providing an organic encapsulation layer (TFE1) on the display element layer (EML) and extended into the trench (T) to completely fill the trench (T) and contact the substrate (SUB) within the trench (T).

14. An electronic device (1) comprising:
a display device (1) including a substrate (SUB) including a display area (DDA) having an emission area (EA) and a non-emission area (NLA), and a non-display area (NDA) which is adjacent to the display area (DDA); and
a display module (11), a processor (12), a memory (13) or a power module (14) connected to the display device (10),
wherein the display area (DDA) of the display device (10) includes:
a transistor layer (TFTL) on the substrate (SUB) and including insulating layers; and
a display element layer (EML) which is electrically connected to the transistor layer (TFTL), the display element layer (EML) including:
a bank structure (BN) on the transistor layer (TFTL), and in which a bank opening in the non-emission area (NLA) and an anode contact hole (ACTH) in the emission area (EA) are defined, the bank structure (BN) having an overhang structure at the bank opening and a side surface which defines the anode contact hole (ACTH);
a first element insulating layer (PDL1) in the anode contact hole (ACTH) and covering the side surface of the bank structure (BN);
a light emitting element (ED) on the first element insulating layer (PDL1); and
a trench (T) which is in the non-emission area (NLA) and adjacent to the light emitting element (ED),
wherein the trench (T) penetrates through the bank structure (BN) of the display element layer (EML) and the insulating layers of the transistor layer (TFTL), the substrate (SUB) being exposed to the trench (T).

15. The electronic device (1) of claim 14, wherein the bank structure (BN) includes:
a first bank layer (BN1);
a second bank layer (BN2) on the first bank layer (BN1);
a third bank layer (BN3) on the second bank layer (BN2) and having a tip (tip) protruding further than an outer side surface (2c) of the second bank layer (BN2) to define the overhang structure at the bank opening; and
the first bank layer (BN1), the second bank layer (BN2) and the third bank layer (BN3) together defining the anode contact hole (ACTH), optionally wherein
the transistor layer (TFTL) further includes conductive layers; and
the conductive layers, the bank structure (BN), the first element insulating layer (PDL1) and the light emitting element (ED) do not overlap the trench (T) in a thickness direction of the substrate (SUB), more optionally, wherein the trench (T) penetrates through the first bank layer (BN1), further optionally wherein the first bank layer (BN1) has a mesh shape.
